# EUROPEAN PATENT APPLICATION

(11) **EP 4 425 797 A1**
(43) Date of publication of application: **04.09.2024**
(21) Application number: 22916461.1
(22) Date of filing: 25.11.2022
(51) Int. Cl.: H04B 1/62, H03F 1/32, G06N 20/00

(54) **METHOD AND DEVICE FOR IMPROVING DATA RECEPTION PERFORMANCE IN COMMUNICATION SYSTEM**

(30) Priority: 27.12.2021 KR 20210188399
(71) Applicant: Samsung Electronics Co., Ltd., Suwon-si, Gyeonggi-do 16677 (KR)
(72) Inventor: JANG, Hyeondeok, Suwon-si, Gyeonggi-do 16677 (KR); KIM, Suhwook, Suwon-si, Gyeonggi-do 16677 (KR); PARK, Yosub, Suwon-si, Gyeonggi-do 16677 (KR); SEO, Bongsung, Suwon-si, Gyeonggi-do 16677 (KR)
(74) Representative: Nederlandsch Octrooibureau
(86) International application number: PCT/KR2022/018867
(87) International publication number: WO 2023/128311

(57) **Abstract**

The present invention relates to a 6G communication system for achieving high data transmission rates and ultra-low latency beyond 4G and 5G communication systems. According to one embodiment of the present invention, provided are a method and device wherein, in order to improve the coverage of a transmission end and the reception performance of a reception end, an AI model is trained on the PA input/output relationship at the reception end, and the trained AI model is used to compensate for PA nonlinearity in received data. In addition, according to one embodiment of the present invention, provided are a method and device wherein training of the AI model on the reception end is only instructed when training of the AI model is necessary, and a reference signal suitable for the training of the AI model is instructed. Accordingly, it is possible to reduce the signaling overhead, computational overhead, or power consumption generated during the training of the AI model. In addition, the reference signal having the same or similar characteristics as the data compensating for PA nonlinearity is used in the training of the AI model, and thus overfitting of the AI model can be prevented. Therefore, the AI model having optimal PA nonlinearity compensation performance can be obtained.

## Description

### [Technical Field]

The disclosure relates to operations of a terminal and a base station in a communication system. Specifically, the disclosure relates to a method and a device for improving data reception performance in a communication system.

### [Background Art]

A review of the development of wireless communication from generation to generation shows that the development has mostly been directed to technologies for services targeting humans, such as voice-based services, multimedia services, and data services. It is expected that connected devices which are exponentially increasing after commercialization of 5G communication systems will be connected to communication networks. Examples of things connected to networks may include vehicles, robots, drones, home appliances, displays, smart sensors connected to various infrastructures, construction machines, and factory equipment. Mobile devices are expected to evolve in various formfactors, such as augmented reality glasses, virtual reality headsets, and hologram devices. In order to provide various services by connecting hundreds of billions of devices and things in the 6G era, there have been ongoing efforts to develop improved 6G communication systems. For these reasons, 6G communication systems are referred to as "beyond-5G" systems.

6G communication systems, which are expected to be implemented approximately by 2030, will have a maximum transmission rate of tera (1,000 giga)-level bps and a radio latency of 100 µ sec. Thus, 6G communication systems will be 50 times as fast as 5G communication systems and have the 1/10 radio latency thereof.

In order to accomplish such a high data transmission rate and an ultra-low latency, it has been considered to implement 6G communication systems in a terahertz band (for example, 95GHz to 3THz bands). It is expected that, due to severer path loss and atmospheric absorption in the terahertz bands than those in mmWave bands introduced in 5G, a technology capable of securing the signal transmission distance (that is, coverage) will become more crucial. It is necessary to develop, as major technologies for securing the coverage, multiantenna transmission technologies including radio frequency (RF) elements, antennas, novel waveforms having a better coverage than OFDM, beamforming and massive MIMO, full dimensional MIMO (FD-MIMO), array antennas, and large-scale antennas. In addition, there has been ongoing discussion on new technologies for improving the coverage of terahertz-band signals, such as metamaterial-based lenses and antennas, hign-dimensional spatial multiplexing technique using orbital angular momentum (OAM), and reconfigurable intelligent surface (RIS).

Moreover, in order to improve the frequency efficiencies and system networks, the following technologies have been developed for 6G communication systems: a full-duplex technology for enabling an uplink (UE transmission) and a downlink (node B transmission) to simultaneously use the same frequency resource at the same time; a network technology for utilizing satellites, high-altitude platform stations (HAPS), and the like in an integrated manner; a network structure innovation technology for supporting mobile nodes B and the like and enabling network operation optimization and automation and the like; a dynamic spectrum sharing technology though collision avoidance based on spectrum use prediction, an artificial intelligence (AI)-based communication technology for implementing system optimization by using AI from the technology design step and internalizing end-to-end AI support functions; and a next-generation distributed computing technology for implementing a service having a complexity that exceeds the limit of UE computing ability by using super-high-performance communication and computing resources (mobile edge computing (MEC), clouds, and the like). In addition, attempts have been continuously made to further enhance connectivity between devices, further optimize networks, promote software implementation of network entities, and increase the openness of wireless communication through design of new protocols to be used in 6G communication systems, development of mechanisms for implementation of hardware-based security environments and secure use of data, and development of technologies for privacy maintenance methods.

It is expected that such research and development of 6G communication systems will enable the next hyper-connected experience in new dimensions through the hyper-connectivity of 6G communication systems that covers both connections between things and connections between humans and things. Specifically, it is expected that services such as truly immersive XR, high-fidelity mobile holograms, and digital replicas could be provided through 6G communication systems. In addition, with enhanced security and reliability, services such as remote surgery, industrial automation, and emergency response will be provided through 6G communication systems, and thus these services will be applied to various fields including industrial, medical, automobile, and home appliance fields.

With the advancement of communication systems as described above, various measures are being discussed to improve data transmission and reception performance, enabling the provision of various services. Specifically, various attempts have recently been made to incorporate AI technology into communication technology.

The AI technology may be implemented in various ways and may also be classified in various ways. By way of example, this may be implemented by applying an algorithm to a dataset, training a mathematical model with the dataset, and performing decision making, such as determining or predicting based on the trained model. The AI technology may be classified as (i) supervised learning in which a ground-truth value (which may indicate an original value or an actual value of data desired to be trained on the model) is given, and the corresponding ground-truth value is used as a labeling value of the data to be trained on the model so as to train the model, (ii) unsupervised learning in which a relationship or characteristic between data is derived using an algorithm without a ground-truth value given, (iii) reinforcement learning in which a model is trained through a reward system, and the like. Here, in the case of the supervised learning, although there is a disadvantage that it is relatively difficult to collect labeled data used for training a model, it has an advantage that it is possible to obtain a model with relatively good inference performance compared to other methods when performing inference such as a specific judgment or prediction by applying the trained model to new data.

In the 5G communication system or next-generation communication system, an operation of signal transmission and reception between a transmission end and a reception end (e.g., a terminal and a base station) is standardized, and thus a signal is transmitted or received according to information (e.g., a time/frequency resource, or the like) known to the transmission end and the reception end. That is, since a dataset capable of training an AI model may be easily obtained from a signal transmitted and received between the transmission end and the reception end, an AI model having good performance may be obtained therethrough.

In order to implement a more efficient communication system by applying AI technology to a communication technology, it is necessary to have specific discussions on what issues AI technology may address in existing communication systems, how to obtain data and a labeling value to train an AI model depending on an issue to be addressed, and how to actually utilize a trained AI model.

The above information is presented as background information only to assist with an understanding of the disclosure. No determination has been made, and no assertion is made, as to whether any of the above might be applicable as prior art with regard to the disclosure.

### [Disclosure]

### [Technical Problem]

In line with the development of communication systems as described above, there is a demand for measures to improve coverage. For example, a method for amplifying transmission power of a transmission signal by using a power amplifier (hereinafter, referred to as PA) at a transmission end side has been proposed. However, the nonlinearity characteristic of the PA may cause a problem that the power is not amplified as much as a power gain of the PA, and the range of coverage improvement at the transmission end is small, or the reception end receives data distorted due to the nonlinearity characteristic of the PA. Therefore, in order to improve the coverage of the transmission end and the data reception performance of the reception end, it is necessary to devise a method for compensating the nonlinearity of the PA.

Furthermore, in case that the reception end compensates for the nonlinearity of the PA by using AI technology, it is necessary to devise a method capable of reducing signaling overhead, computational overhead, and power consumption due to AI model training.

Furthermore, in case that there is a characteristic difference between a signal (e.g., a reference signal) to be used for training the AI model and data to compensate for the nonlinearity of the PA, it is necessary to devise a method for addressing a problem of degradation of performance due to overfitting of the AI model.

### [Technical Solution]

In order to address the problems described above, an embodiment of the disclosure provides a method of a first device in a communication system. The method of the first device may include an operation of determining whether an artificial intelligence (AI) model is trained, an operation of transmitting, based on the determination, control information including at least one of a first indicator indicating whether the AI model is trained or a second indicator indicating a reference signal to be used for training the AI model to a second device, and an operation of transmitting data to the second device.

In addition, an embodiment of the disclosure provides a method of a second device in a communication system. The method of the second device may include an operation of receiving, from a first device, control information including at least one of a first indicator indicating whether an AI model is trained or a second indicator indicating a reference signal to be used for training the AI model, an operation of identifying, based on the control information, an AI model to be used for receiving data, and an operation of receiving, based on the identified AI model, the data from the first device.

In addition, an embodiment of the disclosure provides a first device in a communication system. The first device may include a transceiver; and a controller connected to the transceiver and configured to determine whether an AI model is trained, transmit, based on the determination, control information including at least one of a first indicator indicating whether the AI model is trained or a second indicator indicating a reference signal to be used for training the AI model to the second device, and transmit data to the second device.

In addition, an embodiment of the disclosure provides a second device in a communication system. The second device may include a transceiver; and a controller connected to the transceiver and configured to receive, from a first device, control information including at least one of a first indicator indicating whether an AI model is trained or a second indicator indicating a reference signal to be used for training the AI model, identify, based on the control information, the AI model to be used for receiving data, and receive, based on the identified AI model, the data from the first device.

### [Advantageous Effects]

Various embodiments of the disclosure provide a method and device for compensating for nonlinearity of a PA at a reception end. As such, a coverage of a transmission end and a data reception performance of a reception end may be improved.

An embodiment of the disclosure provides a method and device by which an AI model is trained on the PA input/output relationship at the reception end, and the trained AI model is used to compensate for PA nonlinearity with respect to received data.

In addition, according to one embodiment of the disclosure, provided are a method and device wherein training of the AI model is only indicated to the reception end when training of the AI model is necessary, and a reference signal suitable for the training of the AI model is indicated. Accordingly, it is possible to reduce the signaling overhead, computational overhead, or power consumption generated during the training of the AI model. In addition, the reference signal having the same or similar characteristics as the data of which PA nonlinearity is to be compensated for is used in the training of the AI model, and thus overfitting of the AI model may be prevented. Therefore, the AI model having optimal PA nonlinearity compensation performance may be obtained.

Advantageous effects obtainable from the disclosure may not be limited to the above - mentioned effects, and other effects which are not mentioned may be clearly understood, through the following descriptions, by those skilled in the art to which the disclosure pertains.

### [Description of Drawings]

In order to more clearly describe the technical solutions of the embodiments proposed in this disclosure, drawings of the embodiments will be briefly introduced. The following drawings illustrate embodiments of the disclosure by way of reference only and do not limit the disclosure.
FIG. 1 is a view illustrating a new radio (NR, or 5G) communication system to which the disclosure may be applied.
FIG. 2 is a view illustrating a next generation communication system to which the disclosure may be applied.
FIG. 3 is a view illustrating signal distortion due to a nonlinearity characteristic of a PA according to an embodiment of the disclosure.
FIG. 4 is a view illustrating PA nonlinearity compensation according to an embodiment of the disclosure.
FIG. 5A is a view illustrating a process of training a reference signal-based AI model and compensating for PA nonlinearity according to an embodiment of the disclosure.
FIG. 5B is a view illustrating a process of training a reference signal-based AI model and compensating for PA nonlinearity on a time domain according to an embodiment of the disclosure.
FIG. 6 is a view illustrating a process of training a reference signal-based AI model and compensating for PA nonlinearity on a time domain according to an embodiment of the disclosure.
FIG. 7 is a view illustrating a process of training a reference signal-based AI model and compensating for PA nonlinearity on a time domain according to an embodiment of the disclosure.
FIG. 8A is a view illustrating an operation of a transmission end according to an embodiment of the disclosure.
FIG. 8B is a view illustrating an operation of a reception end according to an embodiment of the disclosure.
FIG. 9 is a view illustrating a process of training a reference signal-based AI model and compensating for PA nonlinearity on a time domain according to an embodiment of the disclosure.
FIG. 10A is a view illustrating an operation of a transmission end according to an embodiment of the disclosure.
FIG. 10B is a view illustrating an operation of a reception end according to an embodiment of the disclosure.
FIG. 11 is a view illustrating a process of training a reference signal-based AI model and compensating for PA nonlinearity according to an embodiment of the disclosure.
FIG. 12 is a view illustrating a procedure for exchanging capability information between a transmission end and a reception end according to an embodiment of the disclosure.
FIG. 13 is a view illustrating a structure of a terminal to which the disclosure may be applied.
FIG. 14 is a view illustrating a structure of a base station to which the disclosure may be applied.

### [Mode for Invention]

Hereinafter, embodiments of the disclosure will be described in detail with reference to the accompanying drawings.

In describing the embodiments, descriptions related to technical contents well-known in the relevant art and not associated directly with the disclosure will be omitted.

Such an omission of unnecessary descriptions is intended to prevent obscuring of the main idea of the disclosure and more clearly transfer the main idea.

For the same reason, in the accompanying drawings, some elements may be exaggerated, omitted, or schematically illustrated. Furthermore, the size of each element does not completely reflect the actual size. Furthermore, the size of each element does not completely reflect the actual size. In the respective drawings, the same or corresponding elements are provided with the same or corresponding reference numerals.

The advantages and features of the disclosure and ways to achieve them will be apparent by making reference to embodiments as described below in detail in conjunction with the accompanying drawings.

However, the disclosure is not limited to the embodiments set forth below, but may be implemented in various different forms. The present embodiments are provided only to completely disclose the disclosure and inform those skilled in the art of the scope of the disclosure, and the disclosure is defined only by the scope of the appended claims. Throughout the specification, the same or like reference signs indicate the same or like elements.

Herein, it will be understood that each block of the flowchart illustrations, and combinations of blocks in the flowchart illustrations, can be implemented by computer program instructions. These computer program instructions can be provided to a processor of a general-purpose computer, special purpose computer, or other programmable data processing apparatus to produce a machine, such that the instructions, which execute via the processor of the computer or other programmable data processing apparatus, create means for implementing the functions specified in the flowchart block or blocks. These computer program instructions may also be stored in a computer usable or computer-readable memory that can direct a computer or other programmable data processing apparatus to function in a particular manner, such that the instructions stored in the computer usable or computer-readable memory produce an article of manufacture including instruction means that implement the function specified in the flowchart block or blocks. The computer program instructions may also be loaded onto a computer or other programmable data processing apparatus to cause a series of operational steps to be performed on the computer or other programmable apparatus to produce a computer implemented process such that the instructions that execute on the computer or other programmable apparatus provide steps for implementing the functions specified in the flowchart block or blocks.

Furthermore, each block in the flowchart illustrations may represent a module, segment, or portion of code, which includes one or more executable instructions for implementing the specified logical function(s). It should also be noted that in some alternative implementations, the functions noted in the blocks may occur out of the order. For example, two blocks shown in succession may in fact be executed substantially concurrently or the blocks may sometimes be executed in the reverse order, depending upon the functionality involved.

As used in embodiments of the disclosure, the "unit" refers to a software element or a hardware element, such as a field programmable gate array (FPGA) or an application specific integrated circuit (ASIC), which performs a predetermined function. However, the "unit" does not always have a meaning limited to software or hardware. The "unit" may be constructed either to be stored in an addressable storage medium or to execute one or more processors. Therefore, the "unit" includes, for example, software elements, object-oriented software elements, class elements or task elements, processes, functions, properties, procedures, sub-routines, segments of a program code, drivers, firmware, micro-codes, circuits, data, database, data structures, tables, arrays, and parameters. The elements and functions provided by the "unit" may be either combined into a smaller number of elements, or a "unit", or divided into a larger number of elements, or a "unit". Moreover, the elements and "units" or may be implemented to reproduce one or more CPUs within a device or a security multimedia card.

In the following description, some of terms and names defined in the 3rd generation partnership project (3GPP) standards (standards for 5G, NR, long term evolution (LTE), or similar systems) may be used for the sake of descriptive convenience. In addition, terms and names used in existing communication systems or newly defined in next-generation communication systems (e.g., 6G and beyond-5G systems) to which the disclosure is applicable may also be used. Use of these terms is not intended to limit the disclosure by the terms and names, and the disclosure may be applied in the same way to systems that conform other standards, and may be changed into other forms without departing from the technical idea of the disclosure.

As used in an embodiment of the disclosure, it will be understood that the singular expressions "a", "an", and "the" includes plural expressions unless the context clearly indicates otherwise.

As used in an embodiment of the disclosure, the terms including an ordinal number, such as "a first" and "a second" may be used to described various elements, but the corresponding elements should not be limited by such terms. The above terms are used merely for the purpose of distinguishing one element from other elements. For example, a first element may be termed a second element, and similarly, a second element may be termed a first element without departing from the scope of protection of the disclosure.

As used in an embodiment of the disclosure, the term "and/or" includes any one or combinations of a plurality of relevant items enumerated.

The terms as used in an embodiment of the disclosure are merely used to describe specific embodiments, and are not intended to limit the disclosure. A singular expression may include a plural expression unless they are definitely different in a context. As used herein, the expression "include" or "have" are intended to specify the existence of mentioned features, numbers, steps, operations, elements, components, or combinations thereof, and should be construed as not precluding the possible existence or addition of one or more other features, numbers, steps, operations, elements, components, or combinations thereof.

As used in the disclosure, the expression "greater than" or "less than" is used to determine whether a specific condition is satisfied or fulfilled, but this is intended only to illustrate an example and does not exclude "greater than or equal to" or "equal to or less than". A condition indicated by the expression "greater than or equal to" may be replaced with a condition indicated by "greater than", a condition indicated by the expression "equal to or less than" may be replaced with a condition indicated by "less than", and a condition indicated by "greater than and equal to or less than" may be replaced with a condition indicated by "greater than and less than".

Before the detailed description of the disclosure, examples of construable meanings of some terms used herein are given below. However, it should be noted that the terms are not limited to the examples of the construable meanings as given below.

In the disclosure, a terminal (or communication terminal) is an entity that communicates with a base station or any other terminal, and may be referred to as a node, a user equipment (UE), a next generation UE (NG UE), a mobile station (MS), a device, a terminal, or the like. The terminal may include at least one of a smartphone, a tablet personal computer (PC), a mobile phone, a video phone, an electronic book reader, a desktop PC, a laptop PC, a netbook computer, a personal digital assistant (PDA), a portable multimedia player (PMP), an MP3 player, a medical device, a camera, and a wearable device. Also, the terminal may include at least one of a television, a digital video disk (DVD) player, an audio, a refrigerator, an air conditioner, a vacuum cleaner, an oven, a microwave oven, a washing machine, an air purifier, a set-top box, a home automation control panel, a security control panel, a media box, a game console, an electronic dictionary, an electronic key, a camcorder, and an electronic photo frame. In addition, the terminal may include at least one of various medical devices (e.g., various portable medical measuring devices (blood glucose monitoring device, heart rate monitoring device, blood pressure measuring device, body temperature measuring device, etc.), magnetic resonance angiography (MRA), magnetic resonance imaging (MRI), computed tomography (CT) machine, ultrasonic machine, etc.), a navigation device, a global positioning system (GPS) receiver, an event data recorder (EDR), a flight data recorder (FDR), a vehicle infotainment device, electronic equipment for a ship (e.g., ship navigation device, gyro-compass, etc.), avionics, a security device, an automobile head unit, a home or industrial robot, a drone, an automatic teller's machine (ATM) in banks, point of sales (POS) in a shop, or Internet of things devices (e.g., light bulb, various sensors, electric or gas meter, sprinkler device, fire alarm, thermostat, streetlamp, toaster, sporting goods, hot water tank, heater, boiler, etc.). Furthermore, the terminal may include various types of multimedia systems capable of communication functions. The disclosure is not limited by the above examples, and the terminal may also be referred to by terms having the same or similar meanings.

In the disclosure, a base station is an entity that communicates with terminals and allocates resources to the terminals, and may be referred to as a base station (BS), a Node B (NB), a next generation radio access network (NG RAN), an access point (AP), a transmission reception point (TRP), a wireless access unit, a base station controller, a node on a network, or the like. Alternatively, according to function split, the base station may be referred to as a central unit (CU) or a distributed unit (DU). However, the disclosure is not limited by the above examples, and the base station may also be referred to by terms having the same or similar meanings.

As used herein, control information may be referred to as a control message or control signaling, or may be referred to as a medium access control (MAC)-control element (CE). downlink control information (DCI), uplink control information (UCI), or a radio resource control (RRC) message according to the context, and the disclosure is not limited by the above examples, and the control information may also be referred to by terms having the same or similar meanings.

As used herein, transmitting a physical channel such as a physical downlink control channel (PDCCH), a physical downlink shared channel (PDSCH), a physical uplink control channel (PUCCH), or a physical uplink shared channel (PUSCH) may mean transmitting a signal (or data) through the corresponding physical channel. In the disclosure, for example, transmitting or receiving a PDCCH may mean transmitting or receiving a signal (e.g., DCI) through the PDCCH. Alternatively, transmitting or receiving a PDSCH may mean transmitting or receiving a signal (e.g., downlink data) through the PDSCH. Alternatively, transmitting or receiving a PUCCH may mean transmitting or receiving a signal (e.g., UCI) through the PUCCH. Alternatively, transmitting or receiving a PUSCH may mean transmitting or receiving a signal (e.g., uplink data) through the PUSCH.

As used herein, a signal may refer to a signal or data carrying control information according to the context.

As used herein, a transmitting end may be referred to as a transmitter or a first device, and may mean a terminal in the case of an uplink and mean a base station in the case of a downlink.

As used herein, a receiving end may be referred to as a receiver or a second device, and may mean a base station in the case of an uplink and mean a terminal in the case of a downlink.

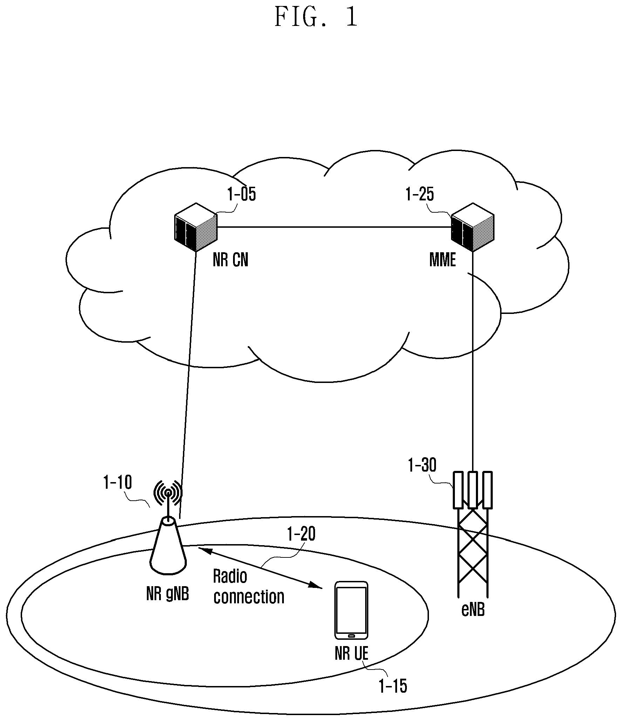

FIG. 1 is a view illustrating a new radio (NR, or 5G) communication system to which the disclosure may be applied.

Referring to FIG. 1, a radio access network of the NR communication system may include an NR base station (or new radio node B or NR gNB) 1-10 and an NR core network 1-05. The NR terminal (or NR UE) 1-15 may access an external network through the NR base station 1-10 and the NR core network 1-05.

In FIG. 1, the NR base station 1-10 corresponds to an LTE base station (evolved Node B (eNB)) of the existing LTE system. The NR base station 1-10 may be connected to the NR terminal 1-15 through a radio channel and may provide superior service than the existing Node B. In the NR system, since all user traffic services are provided through a shared channel, a device that performs scheduling by collecting state information such as buffer state, available transmit power state, and channel state of terminals is required, and the NR base station 1-10 functions as the device. One NR base station may generally control multiple cells. In the NR system, in order to implement high-speed data transmission compared to the LTE system, data transmission and reception may be performed based on a bandwidth equal to or higher than the existing maximum bandwidth, and orthogonal frequency division multiplexing (OFDM) may be used as a radio access technology. In addition, an adaptive modulation & coding (AMF) method for determining a modulation scheme and a channel coding rate according to the channel state of the terminal may be applied. The NR core network 1-05 may perform functions such as mobility support, bearer configuration, and quality of service (QoS) configuration. The NR core network 1-05 corresponds to a device in charge of various control functions as well as a mobility management function for a terminal, and may be connected to multiple base stations. In addition, the NR system may also interwork with the existing LTE system, and the NR core network 1-05 may be connected to a mobility management entity (MME) 1-25 through a network interface, and the MME 1-25 may be connected to an LTE base station 1-30 corresponding to a base station of the LTE communication system.

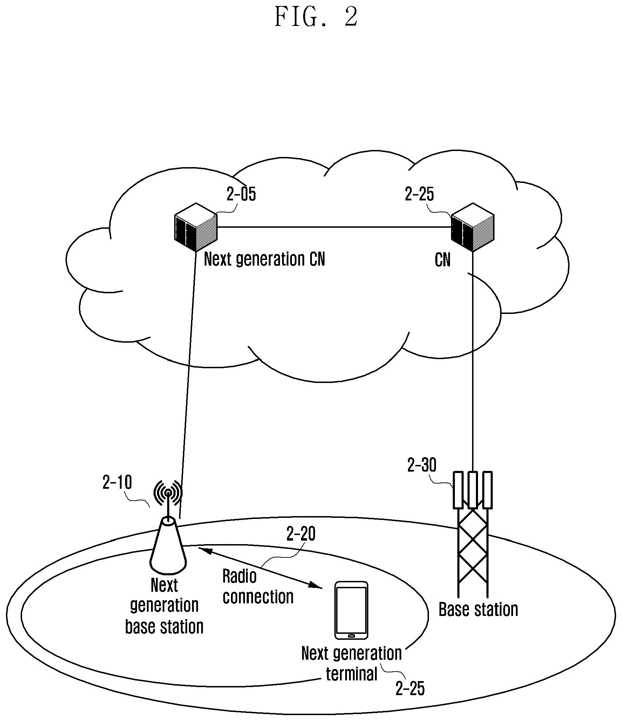

FIG. 2 is a view illustrating a next generation communication system to which the disclosure may be applied.

Referring to FIG. 2, a next-generation communication system may include a next-generation base station 2-10 and a next-generation core network (CN) 2-05. The next-generation terminal 2-15 may access an external network through the next-generation base station 2-10 and the next-generation core network 2-05.

In FIG. 2, the next-generation base station 2-10 may perform a function corresponding to the eNB of the existing LTE communication system or the NR base station (gNB) of the NR communication system described in FIG. 1. Alternatively, in embodiments of the disclosure, the next-generation base station 2-10 may refer to an LTE base station or a NR base station. The next-generation base station 2-10 may be connected to a terminal 2-15 through a radio channel, and may provide a superior communication service than the existing Node B. The next-generation core network 2-05 may perform a function corresponding to the NR core network of the NR communication system described in FIG. 1. In addition, a next-generation communication system to which the disclosure may be applied may interwork with the existing LTE communication system or NR communication system. When interworking with the LTE communication system, connection to an MME 2-25 may be established through a network interface, and the MME may be connected to an eNB 2-30, which is an existing LTE base station. Alternatively, when interworking with the NR communication system, connection to the NR core network 2-25 may be established through a network interface, and the NR core network 2-25 may be connected to the NR base station 2-30. Meanwhile, a next-generation communication system to which the disclosure may be applied is not limited to that shown in FIG. 2. The above-described next-generation communication system may be implemented through various types of base stations, terminals, and core networks, and the disclosure may also be applied to these cases.

As a post-LTE communication system, the above-described 5G communication system or next-generation communication system must freely reflect various requirements of users and service providers. Therefore, services satisfying all of various requirements must be supported. The services considered in the 5G communication system include enhanced mobile broadband (eMBB) communication, massive machine-type communication (mMTC), ultra-reliability low-latency communication (URLLC), and the like.

eMBB aims at providing a higher data rate than that supported by existing LTE, LTE-A, or LTE-Pro. For example, for a single base station, a peak data rate of 20 Gbps must be provided in the downlink, and a peak data rate of 10 Gbps must be provided in the uplink. Furthermore, an increased user-perceived data rate, as well as the maximum data rate, must be provided to the UE. In order to satisfy such requirements, transmission/reception technologies including a further enhanced multi-input multi-output (MIMO) transmission technique are required to be improved. In addition, while the LTE communication system transmits signals by using a transmission bandwidth up to 20MHz in a band of 2GHz used in the system, the 5G communication system considers using a frequency bandwidth more than 20MHz in a frequency band of 3 to 6GHz or 6GHz or more, Through this, the data rate required for the 5G communication system may be obtained.

In addition, mMTC is being considered to support application services such as the Internet of Things (IoT) in the 5G communication system. mMTC has requirements, such as support of connection of a large number of UEs in a cell, enhancement of coverage of UEs, improved battery time, a reduction in the cost of a UE, and the like, in order to effectively provide the Internet of Things. Since the Internet of Things provides communication functions while being provided to various sensors and various devices, it must support a large number of UEs (e.g., 1,000,000 UEs/km2) in a cell. In addition, the UEs supporting mMTC may require wider coverage than those of other services provided by the 5G communication system because the UEs are likely to be located in a shadow area, such as a basement of a building, which is not covered by the cell due to the nature of the service. The UE supporting mMTC must be configured to be inexpensive, and require a very long battery life-time such as 10 to 15 years because it is difficult to frequently replace the battery of the UE.

URLLC may be considered to support a specific-purpose (e.g., mission-critical) cellular-based wireless communication service, For example, URLLC may be used for services such as remote control for robots or machines, industrial automation, unmanned aerial vehicles, remote health care, and emergency alert. Thus, URLLC must provide communication with ultra-low latency and ultra-high reliability. For example, a service supporting URLLC must satisfy an air interface latency of less than 0.5 ms, and also requires a packet error rate of 10⁻⁵ or less. Therefore, for the services supporting URLLC, the 5G system needs to provide a transmit time interval (TTI) shorter than those of other services, and also requires a design for assigning a large number of resources in a frequency band in order to secure reliability of a communication link.

In order to satisfy various services as described above, a wider bandwidth needs to be used. As a result, research is being conducted on methods that utilize a higher bandwidth that has not been used in the past, and research on mmWave and THz is being conducted in next-generation communication systems such as 5G and following 6G. For example, in order to achieve a high data rate, the implementation of the 5G communication system in a mmWave band (e.g., 60 GHz band) has been considered, and for a next-generation communication system such as 6G, research has been conducted to use an ultra-high frequency band that occupies a bandwidth of 0.1 THz to 10 THz. On the other hand, when a signal is transmitted and received in such an ultra-high frequency band, a path loss of radio waves is seriously applied, which may cause a problem of a coverage that a signal transmitted by a transmission end (e.g., a terminal or base station) may reach being reduced. In order to address the coverage reduction problem in the ultra-high frequency band, a method of installing a large number of base stations having narrow coverage has also been proposed, but since a very large number of base stations are required, leading to remarkable increase in initial investment costs (capital expenditures, CAPEX).

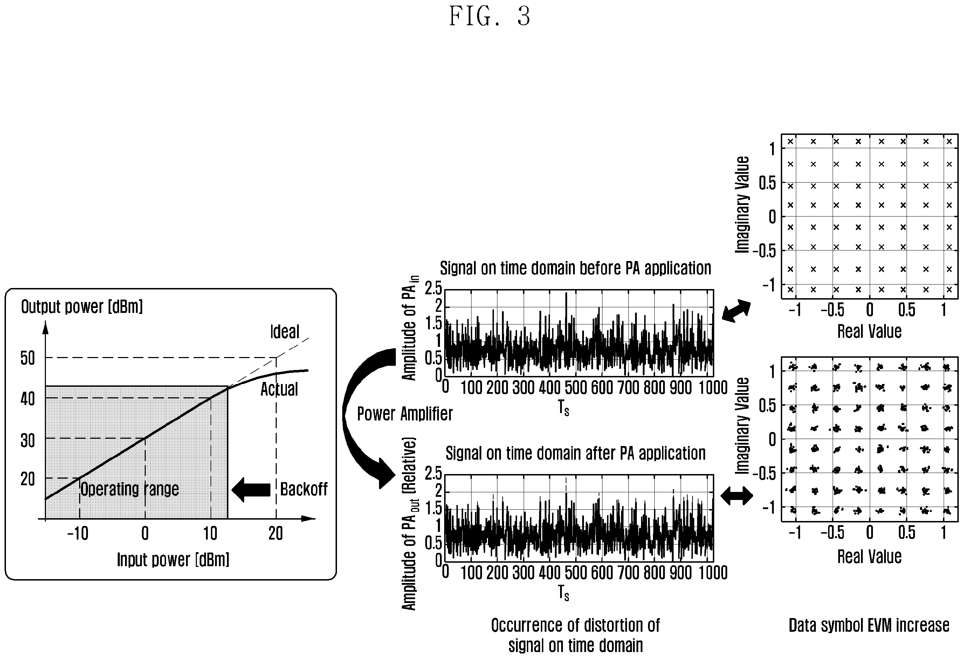

Accordingly, various research has been conducted to address the coverage reduction problem in the ultra-high frequency band. For example, a method for improving a coverage that a transmission signal may reach by amplifying and transmitting transmission power of the transmission signal using a power amplifier (PA) at a transmission end has been proposed. However, even if the transmission end amplifies the transmission power of the transmission signal by using the PA and transmits the transmission signal, there may be a problem that the transmission signal is distorted due to the nonlinearity characteristic of the PA. Hereinafter, a detailed description thereof will be given with reference to FIG. 3.

FIG. 3 is a view illustrating signal distortion due to a nonlinearity characteristic of a PA according to an embodiment of the disclosure.

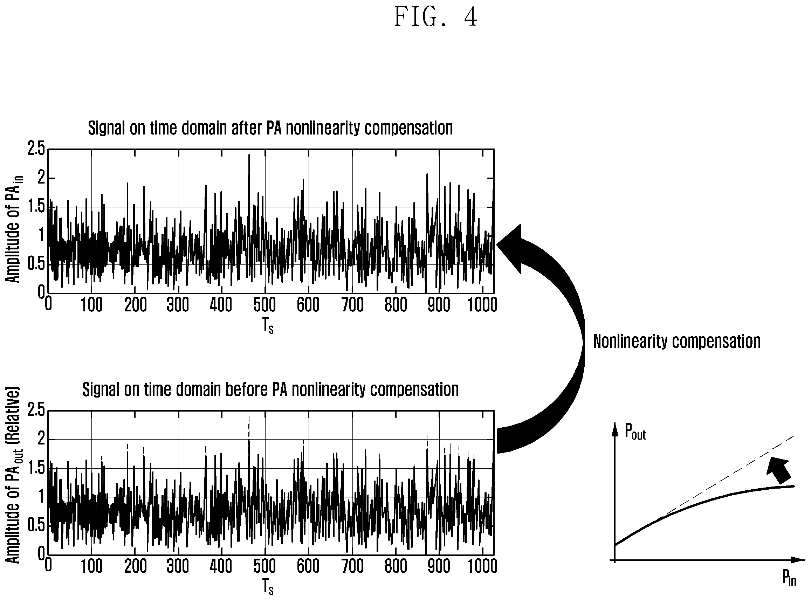

Referring to FIG. 3, in a region where power of a signal input to the PA (i.e., input power) is small (i.e., a small signal area), it is observed a linearity that as the input power (PAᵢₙ) increases, power of a signal output from the PA (i.e., output power, PAₒᵤₜ) increases in proportion to a power gain value G of the PA. However, in a region where the input power of the PA is high, the power of the signal output from the PA (i.e., PAₒᵤₜ) is not amplified by the power gain value G, and nonlinearity in which a phase or amplitude is distorted appears. The nonlinearity characteristic of the PA increases the error vector magnitude (EVM) of an output signal (i.e., a data symbol transmitted from the transmission end to the reception end) of the PA, and eventually causes a problem of degradation of the data reception performance of the reception end. In order to prevent the problem caused by the nonlinearity of the PA, there has proposed a method of applying a power back-off to limit an operating range of the PA to a range where the nonlinearity does not appear and the linearity appears. However, the higher a peak average power ratio (PAPR), the greater the range in which the nonlinearity appears, and in case of increasing the range to which the back-off is applied to prevent the aforementioned case, the transmission power of the transmission signal is amplified to a low power, resulting in decrease of the coverage. Accordingly, in a next-generation communication system such as 6G, various methods for reducing PAPR have been proposed. For example, in order to reduce PAPR, various methods have been proposed, such as a tone reservation method for inserting a tone and a selected mapping (SLM) method for shifting an existing sequence. On the other hand, if the nonlinearity of the PA may be compensated for in addition to the method of narrowing the range in which the nonlinearity appears by reducing the PAPR, the range to which the back-off is applied may be greatly narrowed. Accordingly, the disclosure proposes a method by which a reception end understands the characteristics of an input/output relationship of a PA and compensates for nonlinearity of the PA to receive data. Hereinafter, a detailed description thereof will be given with reference to FIG. 4.

FIG. 4 is a view illustrating PA nonlinearity compensation according to an embodiment of the disclosure.

FIG. 4 illustrates a process of obtaining a signal from which distortion due to the PA nonlinearity is removed by compensating the PA nonlinearity for a signal having transmission power amplified by using the PA (i.e., PAₒᵤₜ).

The reception end of the disclosure may obtain PA input/output relationship information (e.g., a relationship between input power (Pᵢₙ) and output power (Pₒᵤₜ) of the PA), and compensate for nonlinearity with respect to a signal received from the transmission end according to the obtained PA input/output relationship information. For example, the reception end may apply the PA input/output relationship information to a signal received from the transmission end (i.e., an output signal of the PA, PAₒᵤₜ), obtain a signal from which distortion caused by the PA nonlinearity is removed, and decode and process the signal. Therefore, in view of the reception end, signal (or data) reception performance may be improved, and in view of the transmission end, back-off is not applied or the range to which back-off is applied may be greatly reduced, so that the signal may be transmitted with higher power, thereby improving the coverage of the transmission end.

The performance of how accurately the reception end may compensate for PA nonlinearity may depend on how well the obtained PA input/output relationship information at the reception end reflects the actual PA input/output relationship. For example, if the PA input/output relationship information obtained by the reception end does not reflect the actual PA input/output relationship at a corresponding time point, the PA nonlinearity compensation performance of the reception end is degraded. Therefore, it is necessary to devise a method for obtaining PA input/output relation information at the reception end. However, it is a complex task with many variables to be considered for the reception end to identify the input/output relation information of the PA used in the transmission end. Therefore, existing rule-based methods have limitations for the reception end to obtain PA input/output relationship information that accurately reflects the actual PA input/output relationship.

Meanwhile, research on utilizing artificial intelligence (AI) technology as a solution to address complex problems in communication systems has been actively conducted.

For example, there is research underway to train an AI model using a demodulation reference signal (DMRS), a channel state information (CSI) map, or channel quality indicator (CQI) information reported from a terminal to a base station, and to apply the trained AI model to solve complex problems like channel estimation. Alternatively, based on the trained AI model, discussions are underway to quickly process complex problems such as channel coding including LDPC and polar coding. Unlike existing methods that rely on deriving and applying complex formulas or specific rule-based methods, the application of AI technology has the advantage of being able to address complex problems using trained AI models, as long as sufficient datasets for training the AI models are available. In the 5G communication system or next-generation communication system like 6G, to which the disclosure may be applied, an operation of signal transmission and reception between a transmission end and a reception end (e.g., a terminal and a base station) is standardized, and thus the transmission end and the reception end may transmit and receive a signal according to known information (e.g., a time/frequency resource, or the like). Therefore, a dataset capable of training an AI model may be easily collected from a signal transmitted and received between the transmission end and the reception end.

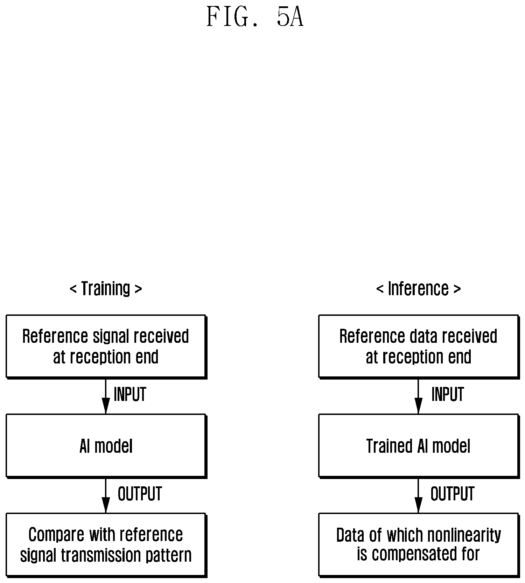

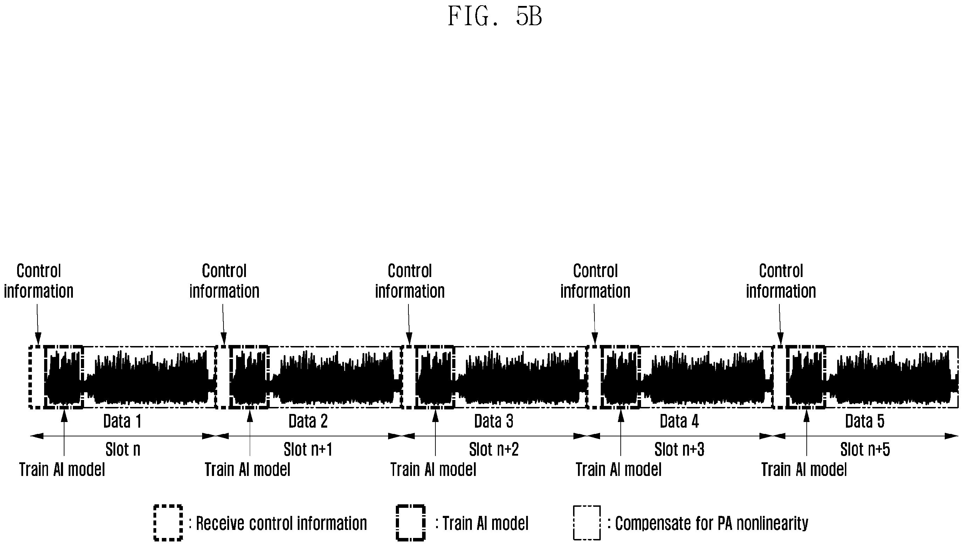

In particular, in a next-generation communication system such as 5G or 6G, to which the disclosure may be applied, a reference signal is transmitted and received based on a pattern known simultaneously by the transmission end and reception end that is based on a predefined or preconfigured pattern (e.g., time and/or frequency resources). Here, the reference signal may include a demodulation-reference signal (DMRS), a channel state information-reference signal (CSI-RS), a sounding reference signal (SRS), a phase tracking-reference signal (PT-RS), or the like. The DMRS corresponds to a reference signal for estimating a channel value required to demodulate a data portion in a received signal and includes an uplink DMRS and a downlink DMRS, and may also be used for power allocation. For example, when the transmission end transmits a DMRS with reference power and notifies the reception end of transmission power, the reception end may compare two power values and calculate a degree of power attenuation in a channel between the transmission end and the reception end. The CSI-RS corresponds to a reference signal transmitted from the base station to the terminal in order to determine a state of a downlink channel. When the base station generates and transmits a CSI-RS to the terminal, the terminal measures the CSI-RS and reports (CSI report) a CSI-RS measurement result associated with the channel state to the base station. Meanwhile, the CSI-RS may be generated by multiplying a pseudo random sequence made using a predefined algorithm by a predesigned weighting sequence. The SRS corresponds to a reference signal transmitted from the terminal to the base station in order to determine a state of an uplink channel. When the terminal transmits an SRS to the base station, the base station measures the SRS and reports a measurement result to the terminal, and the terminal reflects the measurement result in future uplink signal transmission. Furthermore, the PT-RS is used for phase tracking. As described above, the reference signal is transmitted and received between a transmission end and a reception end according to a predefined or preconfigured pattern, and is mainly used to estimate a channel state. A reception end in an existing communication system compares a pattern in which a reference signal is transmitted with a signal actually received to estimate a channel, and the estimated value is used for scheduling, beam management, or an equalizer. On the other hand, the characteristic that the reference signal is transmitted and received according to the predefined or preconfigured pattern may be considered as an advantage when applied to collect datasets for training AI models. Specifically, the pattern in which the reference signal is transmitted is predefined or preconfigured between the transmission end and the reception end, and may be regarded as a kind of ground-truth value. Therefore, when training a supervised learning-based AI model, since the reference signal transmission pattern may be used as a labeling value, a labeled dataset for training the AI model may be easily collected. In this aspect, the disclosure proposes a method of using an AI model to determine a PA input/output relationship at a reception end and training the AI model based on a reference signal in particular. Hereinafter, a detailed description thereof will be given with reference to FIGS. 5A and 5B.

Hereinafter, the training of the AI model described in the disclosure may be implemented as offline-training, for which a well-trained model is loaded from the beginning, or online-training which continuously updates the AI model to reflect the continuously changing environment. Here, the offline-training is a method of pre-training an AI model with a large amount of dataset, and may be used when an AI model is not required to be updated. In other words, it is a method of pre-training an AI model in a design process of a chip embedded in a device, and loading the trained AI model into an algorithm of the chip, so additional training of the AI model is not required. However, in a communication system where a surrounding environment continuously changes, it is difficult to properly reflect the changing communication environment with the fixed AI model, so online-training that may continuously update the AI model needs to be considered. Therefore, in the disclosure, it will be described based on online-training which may continuously update the AI model by training the AI model at a specific period or by training the AI model when a specific event or condition is satisfied. However, the disclosure is not limited thereto, and it is reasonable to expect that the disclosure may be applied even in the case of offline-training.

FIG. 5A is a view illustrating a process of training a reference signal-based AI model and compensating for PA nonlinearity according to an embodiment of the disclosure.

A process of training a reference signal AI model and compensating for a PA nonlinearity proposed in the disclosure may include a training stage and an inference stage.

In the training stage in FIG. 5A, a reception end may train an AI model based on a reference signal. For example, by inputting a reference signal received by the reception end to an AI model, and optimizing an objective function (e.g., minimizing a loss function or maximizing an utility function) with respect to a difference between a result output from the AI model (a value predicted by the reference signal received by the reception end) and a transmission pattern of the corresponding reference signal provided to the reception end by the transmission end, the AI model may be trained. That is, by inputting a reference signal distorted due to PA nonlinearity into an AI model and optimizing a value predicted by the AI model to be close to a transmission pattern of the reference signal, the AI model may be trained to precisely reflect the PA input/output relationship characteristics.

When the training of the AI model is completed, in the inference state of FIG. 5A, the reception end may input a data portion of the received signal to the trained AI model to obtain, as an output value of the AI model, data having a compensated PA nonlinearity, that is, from which the distortion due to the PA nonlinearity is removed. As such, the reception end may process data for which the PA nonlinearity is compensated and thus the data reception performance of the reception end may be improved.

Although the training stage and the inference stage have been described separately in FIG. 5A, the disclosure is not limited thereto. For example, the above-described operations in the training stage and the inference stage may be performed as a series of operations in one stage, or some of the operations may be omitted or performed simultaneously.

Hereinafter, with reference to FIG. 5B, a process of training a reference signal-based AI model and compensating for PA nonlinearity in the time domain will be described.

FIG. 5B is a view illustrating a process of training a reference signal-based AI model and compensating for PA nonlinearity on a time domain.

Referring to FIG. 5B, the reception end may train an AI model based on a reference signal received from the transmission end in every slot, and the PA nonlinearity for a data transmission portion of the signal received in the slot may be compensated for based on the trained AI model. For example, the reception end may train an AI model based on a DMRS received from the transmission end at the beginning of each slot. According to another embodiment, the reception end may train an AI model based on a last received SRS or CSI-RS from the transmission end. As described above, since a location where the reference signal is transmitted and received between the transmission end and reception end is predefined or preconfigured in advance, the reception end may only need to monitor the location where the reference signal used for training the AI model is received and train the AI model based on the received reference signal at the location.

FIG. 5B illustrates that control information is received at the beginning of every slot, and the reference signal is received and used for AI model training, but the disclosure is not limited thereto. For example, the reference signal may be received not only in the beginning of the corresponding slot but also in other sections. Alternatively, the reference signal may be received in a specific symbol section according to a type of the corresponding reference signal.

On the other hand, as shown in FIG. 5B, when the AI model is trained based on the reference signal received for each slot, there is a problem that the use of computational resources and power consumption increase for training the AI model. In addition, since the AI model is trained based on the reference signal received in every slots and the nonlinearity of a transmission portion of a signal received in a slot identical to that of the reference signal used for training the AI model needs to be compensated for, the AI model training is required to proceed very rapidly. This may serve as a constraint that only AI models with low training complexity must be used. In addition, a characteristic difference may occur between a reference signal used for training an AI model and data of which PA nonlinearity is compensated for. For example, quadrature phase shift keying (QPSK) is used for the reference signal, but high order modulation (e.g., 64 QAM, 256 QAM) may be used in a data transmission portion of a signal of which PA nonlinearity is to be compensated for. In addition, there may be a case in which modulation orders of the reference signal used for training the AI model and the data of which PA nonlinearity is compensated for are different from each other. In addition, depending on an ambient temperature or scheduling, there is a different between a PA characteristic in a section in which the reference signal is received and a PA characteristic of a section in which data of which PA nonlinearity is to be compensated for is received so that the reference signal and the data have a difference in characteristics or distribution thereof. As such, when there is considerable variation in the characteristics or distribution between a training dataset (reference signal) of the AI model and a test dataset (data of which PA nonlinearity is to be compensated for), the AI model may be effectively trained to reflect the characteristics of the training dataset but may have a difficulty in accurately reflecting the characteristics of the test dataset, resulting in the issue of overfitting to the training dataset. This is because the trained AI model does not properly compensate for PA nonlinearity, which may eventually lead to deterioration of the reception performance of the reception end.

In order to solve the above-described problem, it is possible to consider a method of performing AI model training only when AI model training is required, for example, when a characteristic of the PA is changed. However, research is underway to investigate the timing and extent of changes in the characteristic of a PA, but it is difficult to derive and apply an accurate equation considering various variables. In addition, it is difficult to predict a characteristic change of a PA in a transmission end only with a characteristic (e.g., a modulation and coding scheme (MCS)) that may be determined by a reception end. In particular, the information about a temperature of the transmission end, which greatly affects the characteristic of the PA, may not be known by the reception end. Therefore, it is efficient for the transmission end to identify whether the characteristic of the PA have changed and inform the reception end whether the AI model has been trained.

As another method, a case in which an AI model is trained when an error of decoding the data received at the reception end increases to a certain level may also be considered. However, since training the AI model at that time point corresponds to retraining in a situation where the error has already occurred, it is less efficient in that it may not support the high transmission and reception throughput compared to the method in which the transmission end informs the reception end whether the AI model has been trained.

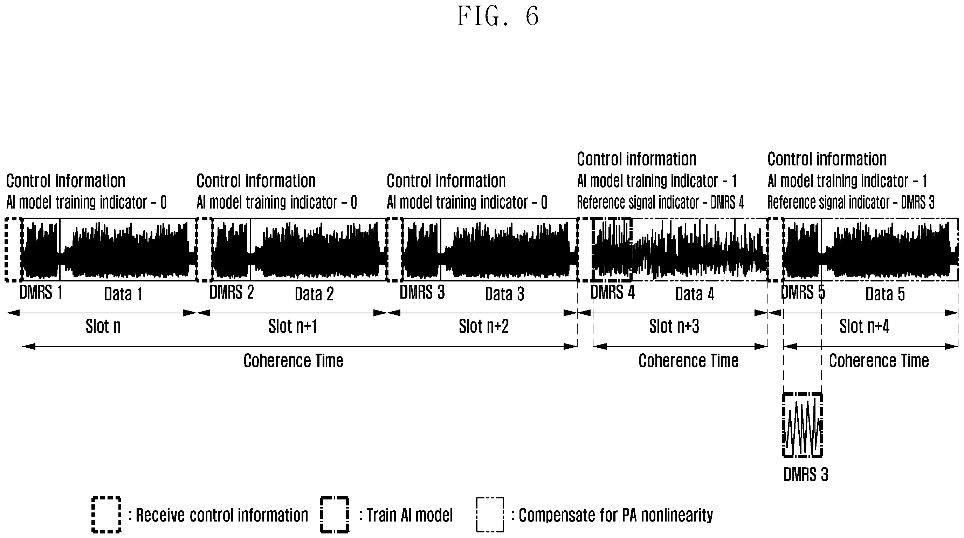

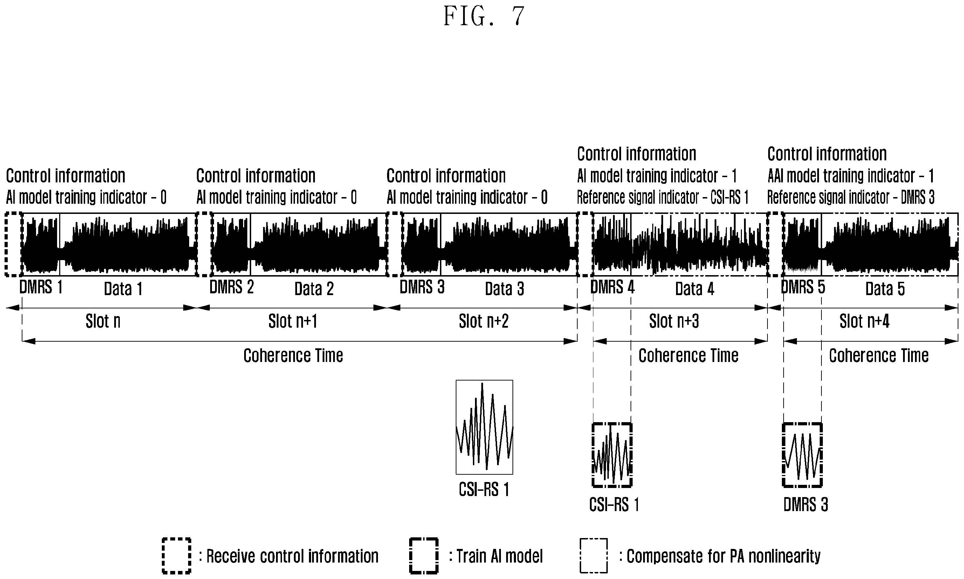

Therefore, the disclosure provides a method by which signaling overhead and computational overhead that may occur when training an AI model may be reduced by indicating of a transmission end to a reception end to train the AI model only when the training of the AI model is necessary. Furthermore, the disclosure provides a method by which a transmission end may select a reference signal suitable for training an AI model and indicate the reference signal to an reception end so as to minimize a characteristic difference between the reference signal to be used for training the AI model and data of which PA nonlinearity is to be compensated for. Hereinafter, a detailed description thereof will be given with reference to FIGS. 6 and 7.

FIG. 6 is a view illustrating a process of training a reference signal-based AI model and compensating for PA nonlinearity on a time domain according to an embodiment of the disclosure.

Referring to FIG. 6, a transmission end may indicate, to a reception end, whether to train an AI model or use a previously trained AI model in a corresponding slot. In addition, when the transmission end indicates the AI model to be trained in a corresponding slot, the transmission end may indicate a reference signal to be used for training the AI model to the reception end. Here, the transmission end may indicate whether to train the AI model based on an event trigger method which indicate whether to train the AI model for each slot or a method which quasi-statically indicate whether to train the AI model so that training of the AI model may be omitted during a specific period (e.g., a period in which a characteristic of the PA does not change). When the reception end has data to be received, the reception end may monitor whether control information (e.g., UCI in case of uplink or DCI in case of downlink) scheduling the data is received. When an indication on whether to train the AI model or an indication for a reference signal to be used for training the AI model is received through the control information, the reception end may determine whether to train the AI model according to the indication from the transmission end and determine a reference signal to be used for training the AI model.

Meanwhile, in the disclosure, a time interval in which a characteristic of a PA is maintained may be referred to as coherence time. In the coherence time during which a characteristic of a PA is maintained, a characteristic or distribution of the reference signal used for training the AI model and a characteristic or distribution of data of which PA nonlinearity is compensated for are maintained and already reflected on the AI model, and thus additional training of the AI model is not necessary. Therefore, the transmission end may indicate the reception end not to train the AI model during the coherence time in order to reduce the overhead caused by training the AI model. In addition, since a time point at which the coherence time ends indicates that the characteristic of the PA has changed instead of being maintained, it is necessary to train the AI model additionally. Accordingly, at the time point at which the coherence time ends, the transmission end may indicate the reception end to train the AI model.

According to an embodiment, the transmission end may indicate whether to perform training of the AI model in the corresponding slot or to use a previously trained AI model through an indicator (e.g., an AI model training indicator or field) within control information (e.g., DCI or UCI). For example, in case that the transmission end determines that the AI model needs to be trained, the transmission end may configure the AI model training indicator within the control information to be "1" so as to be transferred to the reception end and accordingly, the reception end may train the AI model in the corresponding slot. Thereafter, the reception end may compensate for PA nonlinearity for a data portion of a signal received in the corresponding slot based on the trained AI model. Alternatively, in case that the transmission end determines that the AI model does not need to be trained (e.g., in the coherence time), the transmission end may configure the AI model training indicator within the control information to be "0" so as to be transferred to the reception end and the reception end may omit training of the AI model in the corresponding slot. Thereafter, the reception end may compensate for the PA nonlinearity for the data portion of the signal received in the corresponding slot using a previously trained AI model. In addition, according to an embodiment, the transmission end may indicate a reference signal to be used for training the AI model through an indicator (e.g., a reference signal indicator or field) within control information (e.g., DCI or UCI). For example, the reference signal indicator may include N bits, and codepoints of the reference signal indicator may correspond to a reference signal ID and a reference signal type such as DMRS, CSI-RS, or SRS, respectively. Alternatively, for example, a case in which all N bits are configured to 0 may indicate a last received DMRS. If the AI model training indicator in the control information received in slot n+3 is configured to "1" and the reference signal indicator indicates DMRS 4, the reception end may train the AI model based on DMRS 4. Thereafter, the reception end may compensate for PA nonlinearity for a data portion of a signal received in slot n+3 based on the trained AI model Alternatively, if the AI model training indicator in the control information received in slot n+4 is configured to "1" and the reference signal indicator indicates DMRS 3 having been received in previous slot n+3, the reception end may train the AI model based on DMRS 3. Thereafter, the reception end may compensate for PA nonlinearity for a data portion of a signal received in slot n+4 based on the trained AI model. In the above, it has been described that the AI model training indicator may be configured to "0" or "1", but this is for convenience of description and the disclosure is not limited thereto. For example, when the AI model needs to be trained, the AI model training indicator may be configured to "1", and when the AI model does not need to be trained, the AI model training indicator may be configured to "0". Alternatively, depending on whether the AI model needs to be trained, the AI model training indicator may be configured to a specific value different from "0" and "1". This may be equally applied to the following embodiments.

On the other hand, in order to prevent the overfitting problem of the AI model, it is necessary to select, as a reference signal for training the AI model, a reference signal having a characteristic or distribution having a high similarity to the characteristic or distribution of the data of which PA nonlinearity is to be compensated for and the selected reference signal needs to be indicated to the reception end. By considering factors that may affect a characteristic of a PA, such as a type of the PA, PAPR, ratio of signals distorted due to nonlinearity, ambient temperature, degree of heat generation, or scheduling information (information related to multi-user scheduling in the same frequency band or the like), a reference signal to be used for training the AI model may be selected and the selected reference signal may be indicated to the reception end. The above information corresponds to examples that may be considered for selecting a reference signal, but the disclosure is not limited thereto. In the disclosure, a combination of some of the above information or various information other than the above information may be considered for selecting a reference signal, and a result of applying an algorithm to the above information may be considered for selecting a reference signal. Most of the information that may be considered for selecting a reference signal to be used for training the AI model may be easily obtained by the transmission end rather than the reception end. Therefore, hereinafter, the disclosure will illustrate an embodiment in which a transmission end selects a reference signal to be used for training an AI model according to various methods or information and indicates the selected reference signal to a reception end. However, the disclosure is not limited thereto, and may allow an embodiment in which the reception end reports one or more candidate reference signals that may be used for training the AI model to the transmission end, and the transmission end selects and indicates a reference signal to be used for training the AI model from among the candidate reference signals.

Various algorithms may be used when the transmission end determines whether to train the AI model and which reference signal to be used for training the AI model. For example, AI algorithms such as clustering may be used. The transmission end may generate one or more clusters based on factors that may affect a characteristic of the PA, and perform clustering to map each reference signal to belong to a specific cluster based on similarity between the characteristic of the reference signal and a characteristic of the cluster. If a cluster to which data to be transmitted by the transmission end belongs is different from a cluster to which a reference signal used for training the previous AI model belongs, this case may indicate that the characteristic of the PA has changed, and thus the transmission end may indicate the reception end to train the AI model through control information. In this case, the reception end may select one of reference signals belonging to the same cluster as data to be transmitted, one of reference signals having a characteristic which has a highest similarity to a characteristic of data to be transmitted or reference signals belonging to a cluster having a highest similarity to a cluster to which data to be transmitted belongs among reference signals belonging to the same cluster, or a reference signal having a characteristic which has a highest similarity to a characteristic of data to be transmitted among reference signals belonging to a cluster having a highest similarity to a cluster to which the data to be transmitted belongs, and indicate the selected reference signal to the reception end. If a cluster to which data to be transmitted belongs is identical to a cluster to which a reference signal used for training the previous AI model belongs, this case may indicate that the characteristic of the PA have not changed but maintained, and thus the transmission end may indicate the reception end not to train the AI model through control information.

According to another embodiment, a rule-based algorithm may be used. For example, if a temperature changes by 2 degrees or more and the number of component carriers changes to 2, this case may indicate that the characteristic of the PA have changed, and thus the transmission end may indicate the reception end to train the AI model, and may indicate a last received DMRS as a reference signal to be used for training of the AI model. Alternatively, a rule may be applied when a signal of the transmission end is measured through a feedback path and an error of the signal is less than or equal to a predetermined value, so that an AI transmission end may indicate, to a reception end, not to train an AI model, or when an error of the signal is equal to or greater than a predetermined value, so that the transmission end indicates the reception end to train the AI model. Meanwhile, the above-described algorithms are merely examples that may be considered in determining whether an AI model needs to be trained and which reference signal to be used for training an AI model in the disclosure, but the disclosure is not limited thereto.

FIG. 6 illustrates that the AI model training indicator or the reference signal indicator is transferred to the reception end through the control information. Depending on a time scale or importance (e.g., a size of the time interval to which the above-described AI model-based PA nonlinearity compensation method is applied or an importance of a signal transmitted and received in the corresponding time interval), or implementation of the transmission and reception ends, the AI model training indicator or the reference signal indicator may be transferred to the reception end through a DCI (downlink case), UCI (uplink case), medium access control (MAC) control element (CE), or radio resource control (RRC) message. However, the embodiment illustrated in FIG. 6 is merely an example for convenience in description and the disclosure is not limited thereto. For example, although only DMRS is shown as the reference signal used for training the AI model in FIG. 6, a CSI-RS for downlink and an SRS for uplink may be indicated to be used for training the AI model. This will be described in detail with reference to FIG. 7.

FIG. 7 is a view illustrating training of a reference signal-based AI model and compensation for a PA nonlinearity on a time domain according to an embodiment of the disclosure.

Referring to FIG. 7, a transmission end may indicate, to a reception end, whether to perform training of an AI model or use a previously trained AI model in a corresponding slot. In addition, when the transmission end indicates to perform training of the AI model in a corresponding slot, the transmission end may indicate a reference signal to be used for training the AI model to the reception end.

The transmission end may indicate whether to perform training of the AI model in the corresponding slot or use a previously trained AI model through an indicator (e.g., an AI model training indicator or field) in the control information, and indicate a reference signal to be used for training the AI model through an indicator (e.g., a reference signal indicator or field) in control information. The detailed description thereof has been given above with reference to FIG. 6, and thus it will be omitted here.

If the AI model training indicator in the control information received in slot n+3 is configured to "1" and the reference signal indicator indicates CSI-RS 1, the reception end may train the AI model based on CSI-RS 1 having been received in slot n+2. Thereafter, the reception end may compensate for PA nonlinearity for a data portion of a signal received in slot n+3 based on the trained AI model. Alternatively, if the AI model training indicator in the control information received in slot n+3 is configured to "1" and the reference signal indicator indicates DMRS 3 having been received in slot n+2, the transmission end may train the AI model based on DMRS 3. Thereafter, the reception end may perform compensation for PA nonlinearity for a data portion of a signal received in slot n+4 based on the trained AI model.

FIG. 7 illustrates that the AI model training indicator or the reference signal indicator is transferred to the reception end through the control information. Depending on a time scale or importance (e.g., a size of the time interval to which the above-described AI model-based PA nonlinearity compensation method is applied or an importance of a signal transmitted and received in the corresponding time interval), or implementation of the transmission and reception ends, the AI model training indicator or the reference signal indicator may be transferred to the reception end through a DCI (downlink case), UCI (uplink case), MAC CE, or RRC message. However, the embodiment illustrated in FIG. 7 is merely an example for convenience in description and the disclosure is not limited thereto.

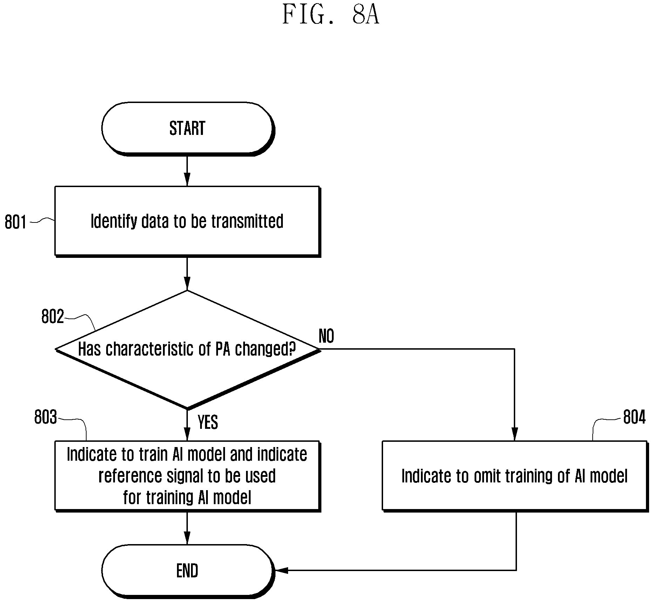

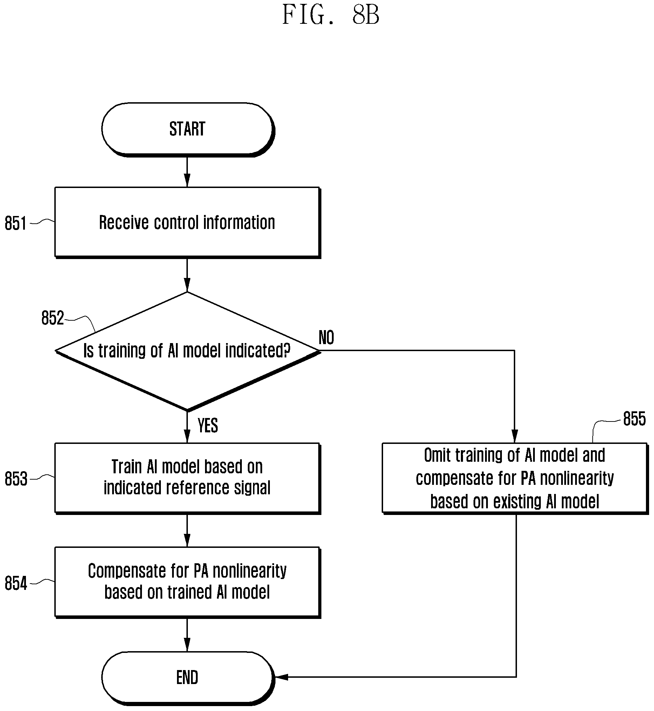

Hereinafter, with reference to FIGS. 8A and 8B, detailed operations of the transmission end and the reception end shown in FIGS. 6 and 7 will be described.

FIG. 8A is a view illustrating an operation of a transmission end according to an embodiment of the disclosure.

In FIG. 8A, the transmission end may refer to a terminal in case of uplink and a base station in case of downlink. In addition, the reception end may refer to a base station in case of uplink and a terminal in case of downlink.

Referring to FIG. 8A, in operation 801, the transmission end may identify data to be transmitted to the reception end.

In operation 802, the transmission end may determine whether to train the AI model. For example, the transmission end may determine whether to train the AI model based on whether a characteristic of a PA (e.g., a PA input/output relationship) has changed. In this case, the transmission end may compare a characteristic of the PA in a section in which the reference signal having been used to training the AI model is transmitted with a characteristic of the PA in a section in which data is to be transmitted and identify whether the characteristic of the PA has changed. For example, based on various factors that may affect the characteristic of the PA, such as a type of the PA, PAPR, ratio of a signal distorted due to nonlinearity, ambient temperature, degree of heat generation, or scheduling information, the transmission end may compare the characteristic of the PA in the section in which the reference signal having been used for training the previous AI model is transmitted with the characteristic of the PA in the section in which data is transmitted and identify whether the characteristic of the PA has changed. Alternatively, the transmission end may identify whether the characteristic of the PA has changed, based on the similarity between the characteristic or distribution of the reference signal having been used for training the previous AI model and the characteristic or distribution of data to be transmitted. If the similarity between the characteristic or distribution of the reference signal having been used for training the previous AI model and the characteristic or distribution of data to be transmitted is low, this case may indicate that the characteristic of the PA has changed, and if the similarity between the characteristic or distribution of the reference signal having been used for training the previous AI model and the characteristic or distribution of data to be transmitted is high, this case may indicate that the characteristic of the PA is maintained without change. Alternatively, the transmission end may generate one or more clusters based on elements that may affect a characteristic of the PA, and perform clustering to map each reference signal to belong to a specific cluster based on similarity between the characteristic of the reference signal and a characteristic of the cluster. If, at the transmission end, the cluster to which the reference signal used for training the previous AI model belongs and the cluster to which data to be transmitted belongs are different, this case may indicate that the characteristic of the PA has changed. Alternatively, if the cluster to which the reference signal used for training the previous AI model belongs and the cluster to which data to be transmitted belongs are different, this case may indicate that the characteristic of the PA is maintained without change.

If it is identified that the characteristic of the PA has changed, in operation 803, the transmission end may indicate, through control information, to the reception end to train the AI model in the corresponding slot and indicate the reference signal to be used for training the AI model to the reception end. For example, the transmission end may configure the AI model training indicator in the control information to "1", configure the reference signal indicator in the control information to a value corresponding to the reference signal determined to be used for training the AI model, and transmit same to the reception end. On the other hand, in order to prevent the overfitting problem of the AI model, it is necessary to select, as a reference signal for training the AI model, a reference signal having a characteristic having a high similarity to that of data of which PA nonlinearity is to be compensated for and the selected reference signal needs to be indicated to the reception end. For example, by considering at least one of a type of the PA, PAPR, ratio of signals distorted due to nonlinearity, ambient temperature, degree of heat generation, or scheduling information (information related to multi-user scheduling in the same frequency band or the like), a reference signal to be used for training the AI model may be selected and the selected reference signal may be indicated to the reception end. The above information corresponds to examples that may be considered for selecting a reference signal, but the disclosure is not limited thereto. In the disclosure, a combination of some of the above information or various information other than the above information may be considered for selecting a reference signal, and a result of applying an algorithm to the above information may be considered for selecting a reference signal. Alternatively, the transmission end may determine one of reference signals belonging to the same cluster as data to be transmitted, one of reference signals having a highest similarity to a characteristic of data to be transmitted or reference signals belonging to a cluster having a highest similarity to a cluster to which data to be transmitted belongs among reference signals belonging to the same cluster, or a reference signal having a characteristic which has a highest similarity to a characteristic of data to be transmitted among reference signals belonging to a cluster having a highest similarity to a cluster to which the data to be transmitted belongs, as a reference signal to be used for training the AI model.

If it is identified that the characteristic of the PA has not changed, in operation 804, the transmission end may indicate, through control information, to the reception end not to train the AI model (to omit training of the AI model) in the corresponding slot. For example, the transmission end may configure the AI model training indicator in the control information to "0" and transfer same to the reception end.

Meanwhile, although each operation is illustrated as being performed in order in FIG. 8A, the disclosure is not limited thereto. Some of operations 801 to 804 of FIG. 8A may be omitted or may be performed simultaneously.

FIG. 8B is a view illustrating an operation of a reception end according to an embodiment of the disclosure.

In FIG. 8B, the transmission end may refer to a terminal in case of uplink and a base station in case of downlink. In addition, the reception end may refer to a base station in case of uplink and a terminal in case of downlink.

Referring to FIG. 8B, in operation 851, the reception end may receive control information from the transmission end.

In operation 852, the reception end may identify whether training of the AI model in the corresponding slot is indicated through the control information. For example, the reception end may identify whether training of the AI model is indicated, based on whether the AI model training indicator in the control information is configured to "0" or "1".

If it is indicated to train the AI model through the control information, in operation 853, the reception end may train the AI model based on the reference signal indicated through the control information. For example, in case that the AI model training indicator in the control information is configure to "1", the reception end may train the AI model based on the reference signal indicated by the reference signal indicator in the control information.

Thereafter, in operation 854, the reception end may compensate for PA nonlinearity for a data portion of the signal received in the corresponding slot based on the trained AI model.

If it is indicated not to train the AI model through the control information, in operation 855, the reception end may omit the training of the AI model in the corresponding slot and use a previously trained AI model to compensate for the PA nonlinearity for a data portion of the received signal in the corresponding slot. For example, in case that the AI training indicator is configured to "0" in the control information, the reception end may omit the training of the AI model in the corresponding slot and use a previously trained AI model to compensate for the PA nonlinearity for a data portion of the received signal in the corresponding slot.

Meanwhile, although each operation is illustrated as being performed in order in FIG. 8B, the disclosure is not limited thereto. Some of operations 851 to 855 of FIG. 8B may be omitted or may be performed simultaneously.

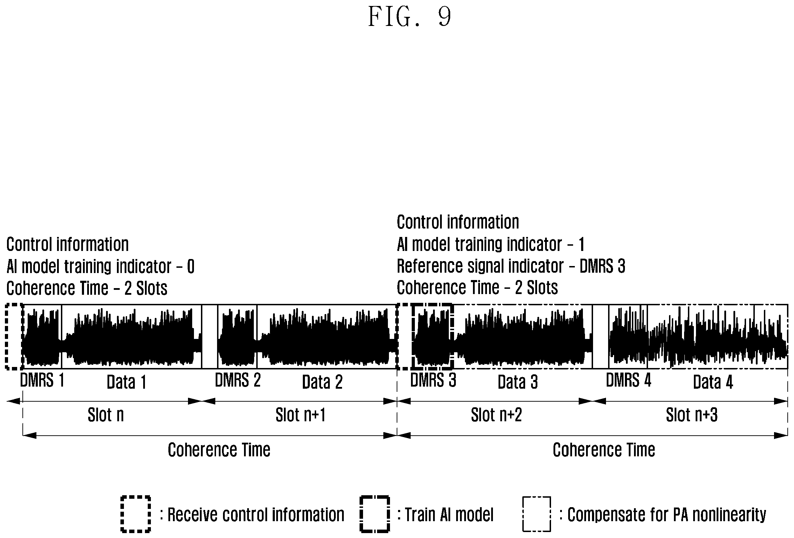

When it is determined that a coherence time in which the characteristic of the PA is maintained the same or similar is long, in order to reduce the overhead caused by control signaling, a method for quasi-statically indicating whether to train the AI model or the reference signal to be used for the AI model may be considered. For example, when whether to train the AI model or the reference signal to be used for the AI model is indicated, information on the coherence time is additionally transmitted, so that the reception end may train the AI model in the corresponding slot and then omit the training of the AI model during the indicated coherence time, or may omit the training of the AI model in the corresponding slot and then additionally omit the training of the AI model during the indicated coherence time. Hereinafter, a detailed description thereof will be given with reference to FIG. 9.

FIG. 9 is a view illustrating a process of training a reference signal-based AI model and compensating for PA nonlinearity on a time domain according to an embodiment of the disclosure.

As shown in FIGS. 6 and 7, a transmission end may indicate, to a reception end, whether to perform training of an AI model or use a previously trained AI model in a corresponding slot. In addition, the transmission end may indicate, to the reception end, a reference signal to be used for training the AI model. Referring to FIG. 9, the transmission end may additionally indicate a coherence time during which a characteristic of a PA is maintained. For example, the transmission end may indicate whether to perform training of the AI model in the corresponding slot or use a previously trained AI model through an indicator (e.g., an AI model training indicator or field) in the control information, indicate the reference signal to be used for training the AI model through an indicator (e.g., a reference signal indicator or field) in control information, and indicate the coherence time through an indicator (e.g., a coherence time indicator or a predetermined field) in the control information. That is, the reception end may inform the transmission end of an interval at which the trained AI model is valid by additionally indicating the coherence time.

For example, if the AI model training indicator in the control information received in slot n is configured to "0" and the coherence time is indicated as 2 slots, the reception end may omit the training of the AI model in slot n and omit the training of the AI model until slot n+1 which corresponds to an end time point of the coherence time, and the transmission end may not transmit control information for indicating whether to train the AI model until the end of the coherence time, as well. In this case, the reception end may reduce power consumption by omitting monitoring whether control information indicating whether to train the AI model is received until the end of the coherence time. Alternatively, if the AI model training indicator in the control information received in slot n+2 is configured to "1", the reference signal indicator is configured to DMRS 3 received in slot n+2, and the coherence time is indicated as 2 slots, the reception end may train the AI model based on DMRS 3 in slot n+2. Thereafter, the reception end may compensate for the nonlinearity of the PA for the data portion of the signal received in slot n+2 based on the trained AI model, and then the reception end may omit the training of the AI model until slot n+3, which corresponds to the end time point of the coherence time. In addition, the transmission end may not transmit control information for indicating whether to train the AI model until the end of the coherence time. In this case, the reception end may reduce power consumption by omitting monitoring whether control information indicating whether to train the AI model is received until the end of the coherence time.

FIG. 9 illustrates that the AI model training indicator, the reference signal indicator and/or the coherence time indicator is transferred to the reception end through the control information. Depending on a time scale or importance (e.g., a size of the time interval to which the above-described AI model-based PA nonlinearity compensation method is applied or an importance of a signal transmitted and received in the corresponding time interval), or implementation of the transmission and reception ends, the AI model training indicator, the reference signal indicator, and/or the coherence time indicator may be transferred to the reception end through a DCI (downlink case), UCI (uplink case), MAC CE, or RRC message. However, the embodiment illustrated in FIG. 9 is merely an example for convenience in description and the disclosure is not limited thereto.

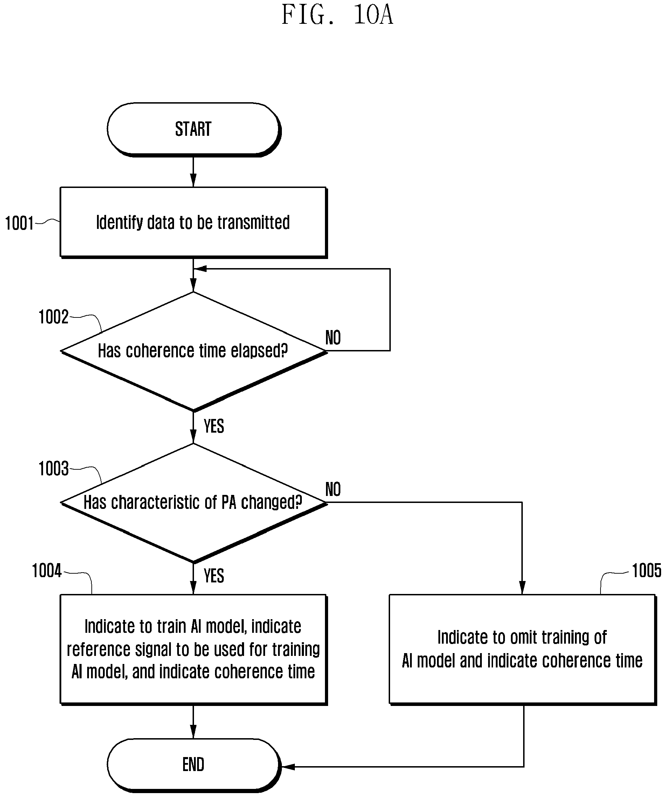

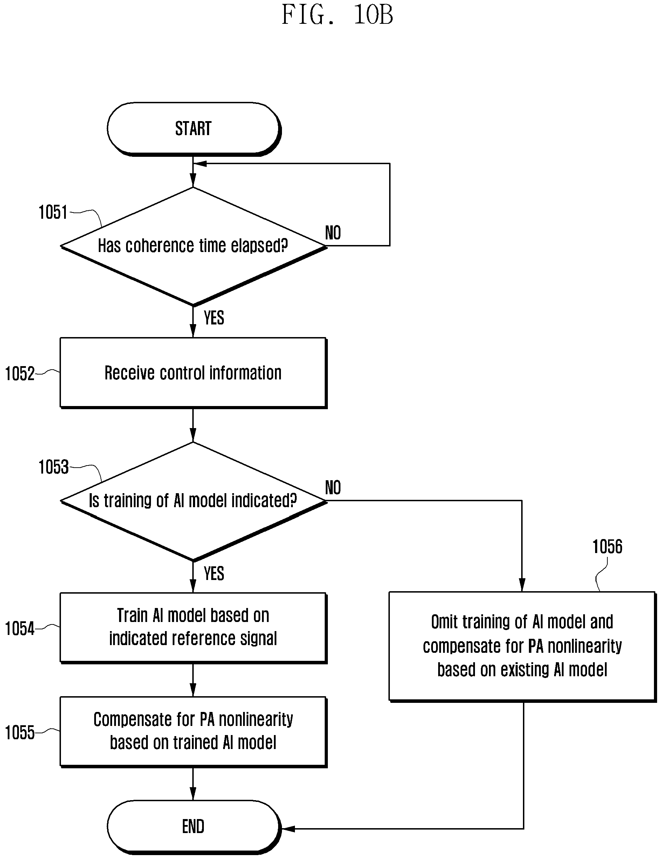

Operations of the transmission end and the reception end described in FIG. 9 will be described in detail with reference to FIGS. 10A and 10B.

FIG. 10A is a view illustrating an operation of a transmission end according to an embodiment of the disclosure.

In FIG. 10A, the transmission end may refer to a terminal in case of uplink and a base station in case of downlink. In addition, the reception end may refer to a base station in case of uplink and a terminal in case of downlink.

Referring to FIG. 10A, in operation 1001, the transmission end may identify data to be transmitted to the reception end.

In operation 1002, the transmission end may identify whether the coherent time has elapsed. For example, based on the coherence time indicator or coherence time information previously indicated to the reception end, the transmission end may identify whether a time point to transmit data belongs to the coherence time or whether a time point to transmit data is after the end of the coherence time.

If it is identified that the coherence time has not elapsed, the transmission end may return to operation 1002 and identify whether the coherence time has elapsed.

Alternatively, if it is identified that the coherence time has elapsed, in operation 1003, the transmission end may determine whether to train the AI model. For example, the transmission end may determine whether to train the AI model based on whether a characteristic of a PA (e.g., a PA input/output relationship) has changed. In this case, the transmission end may compare a characteristic of the PA in a section in which the reference signal having been used to training the AI model is transmitted and a characteristic of the PA in a section in which data is to be transmitted and identify whether the characteristic of the PA has changed. For example, based on various factors that may affect the characteristic of the PA, such as a type of the PA, PAPR, ratio of a signal distorted due to nonlinearity, ambient temperature, degree of heat generation, or scheduling information, the transmission end may compare the characteristic of the PA in the section in which the reference signal having been used for training the AI model is transmitted with the characteristic of the PA in the section in which data is transmitted and identify whether the characteristic of the PA has changed. Alternatively, the transmission end may identify whether the characteristic of the PA has changed, based on the similarity between the characteristic or distribution of the reference signal having been used for training the previous AI model and the characteristic or distribution of data to be transmitted. If the similarity between the characteristic or distribution of the reference signal having been used for training the previous AI model and the characteristic or distribution of data to be transmitted is low, this case may indicate that the characteristic of the PA has changed, and if the similarity between the characteristic or distribution of the reference signal having been used for training the previous AI model and the characteristic or distribution of data to be transmitted is high, this case may indicate that the characteristic of the PA is maintained without change. Alternatively, the transmission end may generate one or more clusters based on elements that may affect a characteristic of the PA, and perform clustering to map each reference signal to belong to a specific cluster based on similarity between the characteristic of the reference signal and a characteristic of the cluster. If, at the transmission end, the cluster to which the reference signal used for training the previous AI model belongs and the cluster to which data to be transmitted belongs are different, this case may indicate that the characteristic of the PA has changed. Alternatively, if the cluster to which the reference signal used for training the previous AI model belongs and the cluster to which data to be transmitted belongs are different, this case may indicate that the characteristic of the PA is maintained without change.

If it is identified that the characteristic of the PA has changed, in operation 1004, the transmission end may indicate, through control information, to the reception end to train the AI model in the corresponding slot and indicate the reference signal to be used for training the AI model to the reception end. Here, the coherence time may be additionally indicated. For example, the transmission end may configure the AI model training indicator in the control information to "1", configure the reference signal indicator to a value corresponding to the reference signal determined to be used for training the AI model, and configure the coherence time indicator to indicate a section in which the characteristic of the PA is maintained the same or similar (or a section in which the characteristic of the PA is expected to be the same or maintained) and transfer same to the reception end. On the other hand, in order to prevent the overfitting problem of the AI model, it is necessary to select, as a reference signal for training the AI model, a reference signal having a characteristic having a high similarity to that of data of which PA nonlinearity is to be compensated for and the selected reference signal needs to be indicated to the reception end. For example, by considering at least one of a type of the PA, PAPR, ratio of signals distorted due to nonlinearity, ambient temperature, degree of heat generation, or scheduling information (information related to multi-user scheduling in the same frequency band or the like), a reference signal to be used for training the AI model may be selected and the selected reference signal may be indicated to the reception end. The above information corresponds to examples that may be considered for selecting a reference signal, but the disclosure is not limited thereto. In the disclosure, a combination of some of the above information or various information other than the above information may be considered for selecting a reference signal, and a result of applying an algorithm to the above information may be considered for selecting a reference signal. Alternatively, the transmission end may determine one of reference signals belonging to the same cluster as data to be transmitted, one of reference signals having a highest similarity to a characteristic of data to be transmitted or reference signals belonging to a cluster having a highest similarity to a cluster to which data to be transmitted belongs among reference signals belonging to the same cluster, or a reference signal having a characteristic which has a highest similarity to a characteristic of data to be transmitted among reference signals belonging to a cluster having a highest similarity to a cluster to which the data to be transmitted belongs, as a reference signal to be used for training the AI model.

Alternatively, if it is identified that the characteristic of the PA has not changed, in operation 1005, the transmission end may indicate, through control information, to the reception end not to train the AI model (to omit training of the AI model) in the corresponding slot, and in this case, the coherence time may be additionally indicated. For example, the transmission end may configure the AI model training indicator in the control information to "0", and configure the coherence time indicator to indicate a section in which the characteristic of the PA is maintained the same or similar (or a section in which the characteristic of the PA is expected to be the same or maintained) and transfer same to the reception end.

Meanwhile, although each operation is illustrated as being performed in order in FIG. 10A, the disclosure is not limited thereto. Some of operations 1001 to 1005 of FIG. 10A may be omitted or may be performed simultaneously.

FIG. 10B is a view illustrating an operation of a reception end according to an embodiment of the disclosure.

In FIG. 10B, the transmission end may refer to a terminal in case of uplink and a base station in case of downlink. In addition, the reception end may refer to a base station in case of uplink and a terminal in case of downlink.

Referring to FIG. 10B, in operation 1051, the reception end may identify whether the coherent time has elapsed.

If it is identified that the coherence time has not elapsed, the reception end may return to operation 1051 and identify whether the coherence time has elapsed. In this case, in order to reduce power consumption, the reception end may omit monitoring whether control information indicating whether to train the AI model is received until the end of the coherence time.

Alternatively, if it is identified that the coherence time has elapsed, in operation 1052, the reception end may monitor whether control information indicating whether to train the AI model is received from the transmission end, and receive the control information according to a monitoring result.

In operation 1053, the reception end may identify whether training of the AI model in the corresponding slot is indicated through the control information. For example, the reception end may identify whether training of the AI model is indicated, based on whether the AI model training indicator in the control information is configured to "0" or "1".

If it is indicated to train the AI model through the control information, in operation 1054, the reception end may train the AI model based on the reference signal indicated through the control information. For example, in case that the AI model training indicator in the control information is configure to "1", the reception end may train the AI model based on the reference signal indicated by the reference signal indicator in the control information.

In operation 1055, the reception end may compensate for PA nonlinearity for a data portion of the signal received in the corresponding slot based on the trained AI model. If the coherence time is indicated through the control information, the reception end may omit the training of the AI model until the indicated coherence time ends after training the AI model, and may compensate for PA nonlinearity for data received based on the AI model trained in operation 1054.

Alternatively, if it is indicated not to train the AI model through the control information, in operation 1056, the reception end may omit the training of the AI model in the corresponding slot and use a previously trained AI model to compensate for the PA nonlinearity for a data portion of the received signal in the corresponding slot. In addition, when the coherence time is indicated through the control information, the reception end may omit the training of the AI model until the indicated coherence time ends, and may compensate for PA nonlinearity for the received data by using the previously trained AI model. For example, if the AI model training indicator in the control information is configured to "0" and the coherence time indicator is configured as 2 slots, the reception end may omit the training of the AI model in the corresponding slot, compensate for PA nonlinearity for the data portion of the received signal by using the previously trained AI model, and compensate for PA nonlinearity for the data portion of the received signal by using the previously trained AI model until 2 slots have elapsed from the corresponding slot. In this case, the transmission may reduce power consumption by omitting monitoring whether control information indicating whether to train the AI model is received from the corresponding slot until the end of the 2 slots indicated by the coherence time.

Meanwhile, although each operation is illustrated as being performed in order in FIG. 10B, the disclosure is not limited thereto. Some of operations 1051 to 1056 of FIG. 10B may be omitted or may be performed simultaneously.

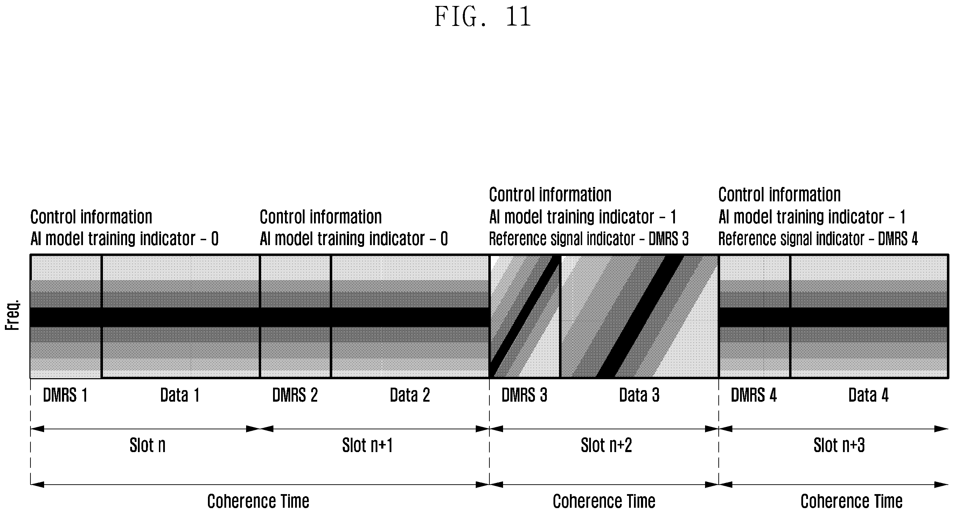

FIGS. 6, 7, and 9 illustrate that a dataset in the time domain is used in the method for training a reference signal-based AI model and compensating for PA nonlinearity proposed in the disclosure, but the disclosure is not limited thereto. For example, a frequency domain dataset (e.g., a channel state information map, or the like) may be used in the method proposed in the disclosure. Hereinafter, a detailed description thereof will be given with reference to FIG. 11.

FIG. 11 is a view illustrating a process of training a reference signal-based AI model and compensating for PA nonlinearity according to an embodiment of the disclosure.

FIG. 11 shows a channel state information map corresponding to a dataset in the frequency domain. Based on the channel state information map, a transmission end may indicate, to a reception end, whether to perform training of an AI model or use a previously trained AI model in a corresponding slot. In addition, the transmission end may indicate, to the reception end, a reference signal to be used for training the AI model. Meanwhile, the transmission end may additionally indicate the coherence time according to the channel state information map. For example, the transmission end may indicate, as the coherence time, a section in which a characteristic of the PA is maintained the same or similar (or a section in which the characteristic of the PA is predicted to be the same or maintained) according to the channel state information map and may indicate whether to train the AI model, a reference signal to be used for training the AI model, or an additional coherence time at the end of the coherence time. As shown in FIGS. 6, 7, and 9, the transmission end may indicate whether to perform training of the AI model in the corresponding slot or use a previously trained AI model through an indicator (e.g., an AI model training indicator or specific field) in the control information, indicate the reference signal to be used for training the AI model through an indicator (e.g., a reference signal indicator or field) in control information, and indicate the coherence time through an indicator (e.g., a coherence time indicator or a predetermined field) in the control information.

For example, if the AI model training indicator in the control information received in slot n is configured to "0" and the coherence time is not indicated or is indicated as 1 slot, the reception end may omit the training of the AI model in slot n. Alternatively, if the AI model training indicator in the control information received in slot n+2 is configured to "1", the reference signal indicator is configured to DMRS 3 received in slot n+2, and the coherence time is not indicated or indicated as 1 slot, the reception end may train the AI model based on DMRS 3 in slot n+2. Thereafter, the reception end may compensate for PA nonlinearity for a data portion of a signal received in slot n+2 based on the trained AI model.

FIG. 11 illustrates that the AI model training indicator, the reference signal indicator and/or the coherence time indicator is transferred to the reception end through the control information. Depending on a time scale or importance (e.g., a size of the time interval to which the above-described AI model-based PA nonlinearity compensation method is applied or an importance of a signal transmitted and received in the corresponding time interval), or implementation of the transmission and reception ends, the AI model training indicator, the reference signal indicator, and/or the coherence time indicator may be transferred to the reception end through a DCI (downlink case), UCI (uplink case), MAC CE, or RRC message. However, the embodiment illustrated in FIG. 11 is merely an example for convenience in description and the disclosure is not limited thereto.

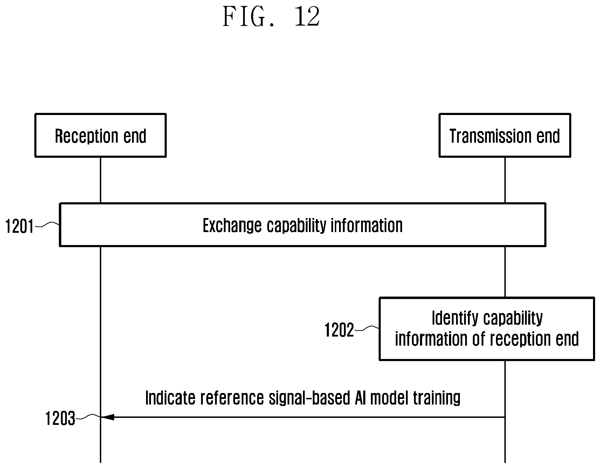

On the other hand, it may be determined whether the transmission end or the reception end may perform the reference signal-based AI model training and PA nonlinearity compensation method proposed by the disclosure according to capabilities supported by each of the transmission end and the reception end of the disclosure and/or a manner of the transmission and reception ends implemented, etc. That is, in order for the transmission end and the reception end to properly operate according to the above-described embodiments, capability information for whether to support reference signal-based AI model training and PA nonlinearity compensation, and whether to process an indicator (at least one of the AI model training indicator, the reference signal indicator, and/or the coherent time indicator) proposed in the disclosure needs to be exchanged between the transmission end and the reception end in advance. Hereinafter, a detailed description thereof will be given with reference to FIG. 12.

FIG. 12 is a view illustrating a procedure for exchanging capability information between a transmission end and a reception end according to an embodiment of the disclosure.

In FIG. 12, the transmission end may refer to a terminal in case of uplink and a base station in case of downlink. In addition, the reception end may refer to a base station in case of uplink and a terminal in case of downlink.

Referring to FIG. 12, in operation 1201, the transmission end and the reception end may exchange capability information including whether to support reference signal-based AI model training and PA nonlinearity compensation, and whether to process an indicator (at least one of the AI model training indicator, the reference signal indicator, and/or the coherent time indicator) proposed in the disclosure, etc.

For example, the transmission end may transmit a message inquiring whether the reference signal-based AI model training and PA nonlinearity compensation are supported to the reception end. In response to the inquiry message, the reception end may transmit a response message regarding whether the reference signal-based AI model training and PA nonlinearity compensation are supported to the transmission end. If the reception end supports the reference signal-based AI model training and PA nonlinearity compensation (operation 1202), the transmission end may transmit, to the reception end, a message inquiring whether at least one of the AI model training indicator, the reference signal indicator, and/or the coherent time indicator is supported, and the reception end may transmit, to the transmission end, a response message regarding whether at least one of the AI model training indicator, the reference signal indicator, and/or the coherent time indicator is supported. If the reception end supports the AI model training indicator, the reference signal indicator, and/or the coherent time indicator (operation 1202), as shown in FIGS. 6 to 11, the transmission end may indicate to the reception end to train the AI model based on the reference signal and compensate for the PA nonlinearity for the received data, based on the trained AI model (operation 1203).

According to another embodiment, the transmission end may transmit, to the reception end, a message inquiring whether to support reference signal-based AI model training and PA nonlinearity compensation, whether to support an indicator (at least one of the AI model training indicator, the reference signal indicator, and/or the coherent time indicator) proposed in the disclosure, and the like (operation 1201). In response to the inquiry message, the reception end may transmit, to the transmission end, a response message regarding whether to support reference signal-based AI model training and PA nonlinearity compensation, whether to support an indicator (at least one of the AI model training indicator, the reference signal indicator, and/or the coherent time indicator) proposed in the disclosure, and the like (operation 1201). If the reception end supports the reference signal-based AI model training and PA nonlinearity compensation and support the AI model training indicator, the reference signal indicator, and/or the coherent time indicator (operation 1202), as shown in FIGS. 6 to 11, the transmission end may indicate to the reception end to train the AI model based on the reference signal and compensate for the PA nonlinearity for the received data, based on the trained AI model (operation 1203).

Meanwhile, the above-described procedure for exchanging capability information between the transmission end and the reception end may be performed within a process in which the transmission end and the reception end establish an initial connection or may be selectively triggered by the transmission end. For example, when the transmission end determines that capability information of the reception end needs to be updated, the aforementioned capability information exchange procedure may be triggered.

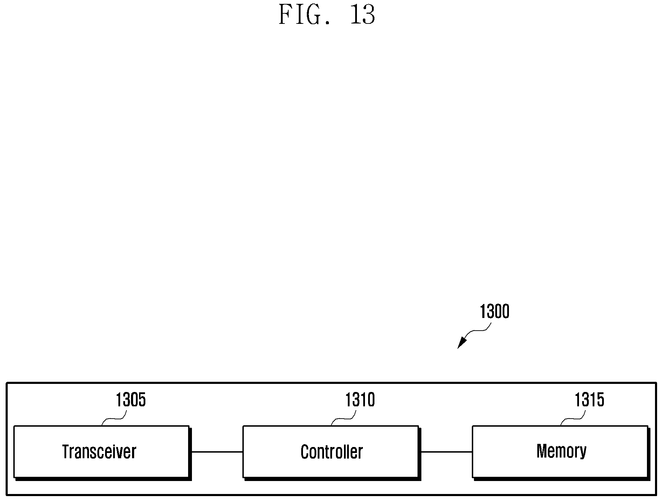

FIG. 13 is a view illustrating a structure of a terminal to which the disclosure may be applied.

Referring to FIG. 13, the terminal 1300 according to an embodiment of the disclosure may include a transceiver 1305, a controller 1310, and a memory 1315. In the disclosure, the controller 1310 of the terminal 1300 may be defined as a circuit or an application-specific integrated circuit or at least one processor. The transceiver 1305 may transmit or receive a signal. The transceiver 1305 may transmit, for example, a signal to a base station and receive a signal from the base station according to an embodiment of the disclosure.

The controller 1310 may control overall operations of the terminal 1300 according to the embodiments proposed in the disclosure. For example, the controller 1310 may control signal flow between respective blocks to perform an operation according to the above-described drawings (or flowchart or signal flow).

The memory 1315 may store at least one of information transmitted and received through the transceiver 1305 and information generated through the controller 1310.

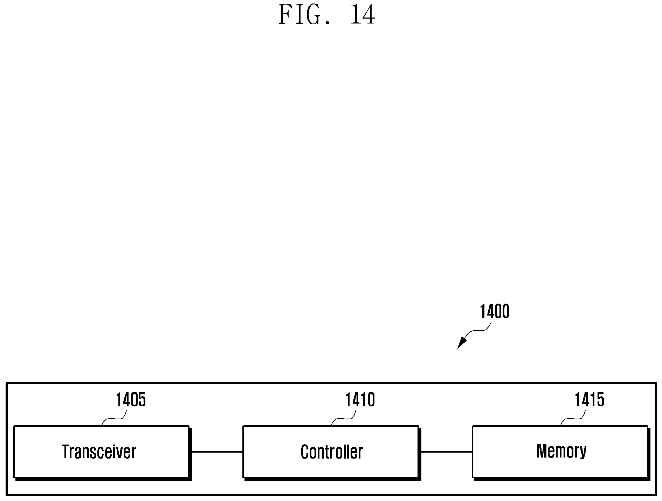

FIG. 14 is a view illustrating a structure of a base station to which the disclosure may be applied.

Referring to FIG. 14, the base station 1400 according to an embodiment of the disclosure may include a transceiver 1405, a controller 1410, and a memory 1415. In the disclosure, the controller 1410 of the base station 1400 may be defined as a circuit or an application-specific integrated circuit or at least one processor. The transceiver 1405 may transmit or receive a signal. The transceiver 1405 may transmit, for example, a signal to a terminal and receive a signal from the terminal according to an embodiment of the disclosure.

The controller 1410 may control overall operations of the base station 1400 according to the embodiments proposed in the disclosure. For example, the controller 1410 may control signal flow between respective blocks to perform an operation according to the above-described drawings (or flowchart or signal flow).

The memory 1415 may store at least one of information transmitted and received through the transceiver 1405 and information generated through the controller 1410.

The reference signal-based AI model training and PA nonlinearity compensation method proposed in the disclosure have been described above. According to the method proposed in the disclosure, if the reception end may compensate for PA nonlinearity, with respect to the reception end, the signal (or data) reception performance may be improved, and with respect to the transmission end, it is possible to transmit signals with higher power by not applying back-off or by significantly reducing the range over which back-off is applied. As such, the coverage of the transmission end may be improved.

In addition, according to the method proposed in the disclosure, it is possible to address signaling overhead and computational overhead issues compared to conventional AI model training methods, and furthermore, to mitigate the problem of AI model overfitting. Specifically, in a conventional method, the AI model is trained based on the received reference signal for each slot, but since the AI model needs to be trained for each slot, overhead such as use of computational resources and power consumption greatly increases. In particular, in the case of a terminal with insufficient computing resources and battery capacity, the overhead due to AI model training may significantly impact terminal operation. In addition, since the AI model must be trained based on the reference signal received immediately before PA nonlinearity compensation, the time required to train the AI model is insufficient, and there is a constraint to use an AI model with a small amount of computation but low performance. In contrast, according to the method proposed in the disclosure, the transmission end may indicate to the reception end to train the AI model only when the AI model is required to be trained, such as when the PA characteristic changes or when the characteristic of the reference signal previously used for training the AI model and the characteristic of the data of which PA nonlinearity is to be compensated for are different, and thus it is possible to obtain an effect of significantly reducing overhead due to continuous AI model training.

Furthermore, the modulation orders and PAPRs of the reference signal used for training the AI model and the data of which PA nonlinear is to be compensated may be different from each other, or the characteristics or distributions of the reference signal and the data may be different depending on the ambient temperature, scheduling information, etc. Here, in a conventional method, the AI model is trained based on the reference signal received immediately before PA nonlinearity compensation, thus causing the overfitting problem of the AI model, that is the AI model reflects the characteristic of the reference signal which is the training dataset, well, but does not reflect the characteristic of the data, which is the test dataset, well. On the other hand, according to the method proposed in the disclosure, instead of the reference signal received immediately before PA nonlinearity compensation, a reference signal having a characteristic similar to that of the data of which PA nonlinearity is to be compensated for is indicated to be used for training the AI model, and thus, it is possible to obtain the effect of preventing overfitting of the AI model.

In the above, the embodiments in which, in order to train the AI model used for the compensation of PA nonlinearity, the transmission end indicates the reception end whether to train the AI model based on the reference signal have been described, but the disclosure is not limited thereto. For example, the method for indicating, to the reception end, whether to train the reference signal-based AI model, the reference signal to be used for AI model training, or the coherence time proposed in the disclosure may be applied not only to train the AI model used for PA nonlinearity compensation, but also to general training of the AI model in the transmission end or the reception end.

In the methods proposed in the disclosure, some or all of the contents included in the respective embodiments may be implemented in combination without departing from the essential spirit and scope of the disclosure.

The embodiments of the disclosure described and shown in the specification and the drawings are merely specific examples that have been presented to easily explain the technical contents of embodiments of the disclosure and help understanding of embodiments of the disclosure, and are not intended to limit the scope of embodiments of the disclosure. That is, it will be apparent to those skilled in the art that other variants based on the technical idea of the disclosure may be implemented.

Furthermore, although exemplary embodiments of the disclosure have been described and shown in the specification and the drawings by using particular terms, they have been used in a general sense merely to easily explain the technical contents of the disclosure and help understanding of the disclosure, and are not intended to limit the scope of the disclosure. It will be apparent to those skilled in the art that, in addition to the embodiments disclosed herein, other variants based on the technical idea of the disclosure may be implemented.

## Claims

1. A method of a first device in a communication system, the method comprising:
determining whether to train an artificial intelligence (AI) model;
transmitting, based on the determination, control information to a second device, comprising at least one of a first indicator indicating whether to train the AI model or a second indicator indicating a reference signal to be used for training the AI model; and
transmitting data to the second device.

2. The method of claim 1,
wherein the transmitting of the control information comprises:
in case that the AI model is determined to be trained, transmitting, to the second device, the control information comprising the first indicator indicating to train the AI model and the second indicator; and
in case that a training of the AI model is determined to be omitted, transmitting, to the second device, the control information comprising the first indicator indicating to omit the training of the AI model, and
wherein the control information is transmitted through one of a downlink control information (DCI), uplink control information (UCI), a medium access control (MAC) control element (CE), or a radio resource control (RRC) message.

3. The method of claim 2, wherein the control information further comprises a third indicator indicating a coherence time, and
wherein the training of the AI model is omitted during the coherence time.

4. The method of claim 3, further comprising receiving capability information of the second device from the second device,
wherein the capability information comprises at least one of information on whether reference signal-based AI model training is supported, or information on whether the first indicator, the second indicator, and the third indicator are supported.

5. A method of a second device in a communication system, the method comprising:
receiving, from a first device, control information comprising at least one of a first indicator indicating whether to train an artificial intelligence (AI) model or a second indicator indicating a reference signal to be used for training the AI model;
identifying, based on the control information, the AI model to be used for receiving data; and
receiving, based on the identified AI model, the data from the first device.

6. The method of claim 5, wherein the identifying of the AI model comprises:
in case that the first indicator indicates to train the AI model, training the AI model based on the reference signal indicated by the second indicator; and
in case that the first indicator indicates to omit a training of the AI model, omitting the training of the AI model.

7. The method of claim 6, wherein the control information further comprises a third indicator indicating a coherence time,
wherein the training of the AI model is omitted during the coherence time, and
wherein the control information is received through one of a downlink control information (DCI), uplink control information (UCI), a medium access control (MAC) control element (CE), or a radio resource control (RRC) message.

8. The method of claim 7, further comprising transmitting capability information of the second device to the first device,
wherein the capability information comprises at least one of information on whether reference signal-based AI model training is supported, or information on whether the first indicator, the second indicator, and the third indicator are supported.

9. A first device in a communication system, the first device comprising:
a transceiver; and
a controller connected to the transceiver and configured to determine whether to train an artificial intelligence (AI) model, transmit to a second device, based on the determination, control information comprising at least one of a first indicator indicating whether to train the AI model or a second indicator indicating a reference signal to be used for training the AI model, and transmit data to the second device.

10. The first device of claim 9, wherein the controller is configured to:
in case that the AI model is determined to be trained, transmit, to the second device, the control information comprising the first indicator indicating to train the AI model and the second indicator; and
in case that a training of the AI model is determined to be omitted, transmit, to the second device, the control information comprising the first indicator indicating to omit the training of the AI model, and
wherein the control information is transmitted through one of a downlink control information (DCI), uplink control information (UCI), a medium access control (MAC) control element (CE), or a radio resource control (RRC) message.

11. The first device of claim 10, wherein the control information further comprises a third indicator indicating a coherence time, and
wherein the training of the AI model is omitted during the coherence time.

12. The first device of claim 11, wherein the controller is configured to receive capability information of the second device from the second device, and
wherein the capability information comprises at least one of information on whether reference signal-based AI model training is supported, or information on whether the first indicator, the second indicator, and the third indicator are supported.

13. A second device in a communication system, the second device comprising:
a transceiver; and
a controller connected to the transceiver and configured to receive, from a first device, control information comprising at least one of a first indicator indicating whether to train an artificial intelligence (AI) model or a second indicator indicating a reference signal to be used for training the AI model, and identify, based on the control information, an AI model to be used for receiving data, and receive, based on the identified AI model, the data from the first device.

14. The second device of claim 13, wherein the controller is configured to:
in case that the first indicator indicates to train the AI model, train the AI model based on the reference signal indicated by the second indicator; and
in case that the first indicator indicates to omit a training of the AI model, omit the training of the AI model.

15. The second device of claim 14, wherein the control information further comprises a third indicator indicating a coherence time,
wherein the training of the AI model is omitted during the coherence time,
wherein the control information is received through one of a downlink control information (DCI), uplink control information (UCI), a medium access control (MAC) control element (CE), or a radio resource control (RRC) message,
wherein the controller is configured to transmit capability information of the second device to the first device, and
wherein the capability information comprises at least one of information on whether reference signal-based AI model training is supported, or information on whether the first indicator, the second indicator, and the third indicator are supported.
